# EUROPÄISCHE PATENTSCHRIFT

(11) **EP 3 794 750 B1**
(45) Veröffentlichungstag und Bekanntmachung des Hinweises auf die Patenterteilung: **11.06.2025**
(21) Anmeldenummer: 19725076.4
(22) Anmeldetag: 14.05.2019
(51) Int. Cl.: H04B 17/12, H04B 17/21, H04B 17/13, H03F 3/24, H04B 1/04, H04B 1/18

(54) **ANTENNENEINHEIT, SENDESYSTEM UND VERFAHREN ZUM BETREIBEN EINER ANTENNENEINHEIT**
ANTENNA UNIT, TRANSMISSION SYSTEM AND METHOD FOR OPERATING AN ANTENNA UNIT
UNITÉ D'ANTENNE, SYSTÈME D'ÉMISSION ET PROCÉDÉ DE FONCTIONNEMENT D'UNE UNITÉ D'ANTENNE

(30) Priorität: 14.05.2018 DE 102018207430
(43) Veröffentlichungstag der Anmeldung: 24.03.2021
(73) Patentinhaber: Molex, LLC, Lisle, IL 60532 (US)
(72) Erfinder: NAST, Helmut, 12557 Berlin (DE); BARTSCH, Thomas, 15806 Zossen (DE); LEHMANN, Lars, 15745 Wildau (DE); SAYED, Ahmed, 12355 Berlin (DE)
(74) Vertreter: Ramrath, Lukas
(86) Internationale Anmeldenummer: PCT/EP2019/062345
(87) Internationale Veröffentlichungsnummer: WO 2019/219682

(56) Entgegenhaltungen:
- EP-A1- 0 461 314
- DE-A1- 102015 217 695
- US-A1- 2005 130 595
- US-A1- 2007 129 031
- US-A1- 2013 002 357

## Beschreibung

Die Erfindung betrifft eine selbstkalibrierende Antenneneinheit, ein Sendesystem mit einer solchen Antenneneinheit sowie ein Verfahren zum Betreiben einer solchen Antenneneinheit.

Aus dem Stand der Technik bekannt sind Antenneneinheiten, die Kabelverluste einer Kabelverbindung zwischen der Antenneneinheit und einer Signalbereitstellungseinheit, z.B. einem Modem, kompensieren.

So offenbart z.B. die US 9,191,903 B2 ein Verfahren sowie eine Vorrichtung zur effizienten externen Steuerung einer Sendeleistung einer Antenneneinheit. Wesentlich für die Steuerung ist ein Feedbacksignal, welches die Signalbereitstellungseinheit von der Antenneneinheit empfängt.

Die US 9,491,713 B2 offenbart ein Kompensationsmodul, welches mit einer Sende-/ Empfangseinheit und mit einem Antennenkabel verbunden werden kann. Das Kompensationsmodul erzeugt einen Parameter, der eine Ausgangssendeleistung repräsentiert und überträgt diesen Parameter zu der Sende-/Empfangseinheit über das Antennenkabel.

Nachteilig bei diesen Lösungen ist, dass für den Betrieb der Antenneneinheit, insbesondere zur Einstellung eines Verstärkungsfaktors, eine Signalübertragung von der Antenneneinheit zur Signalbereitstellungseinheit erforderlich ist. Hierzu müssen entsprechende Signalschnittstellen und Signalverarbeitungsprozesse vorgesehen werden. Insgesamt resultiert ein solcher Ansatz somit in einem komplexen und auch kostenverursachenden System.

Weiter bekannt ist die US 7,965,977 B2. Diese offenbart einen Antennenschaltkreis mit einer Verstärkereinheit zur Verstärkung eines Sendesignals. Eine Steuereinheit steuert den Betrieb des Sendeverstärkers. In diesem Verfahren ist ein sogenanntes T/R-Steuersignal vorgesehen, welches einen Kabelverlust in einem Koaxialkabel, an den der Antennenschaltkreis angeschlossen ist, repräsentiert.

Weiter bekannt ist die US 5,634,191, die offenbart, dass eine Signalstärke von einer sogenannten Basisstation-Erweiterungseinheit bestimmt wird und als Datenstrom kodiert an eine sogenannte Mikrozellen-Erweiterungseinheit mit einer Antenne übertragen wird.

Die US2005/130595 A1 offenbart eine Leistungssteuerungseinrichtung und ein Verfahren zum Kalibrieren der Leistung eines Senders oder Empfängers eines mobile Kommunikationsnetzwerks.

Die US2013/002357 A1 offenbart eine Vorrichtung umfassend einen Leistungsregelkreis zum Empfang eines Feedbacksignals von einem Leistungsverstärker und zur Erzeugung eines ersten Steuersignals zum Steuern eines variable Verstärkers.

Die EP 0 461 314 A1 offenbart Sendeamplitudenkontroll- oder -stabilisierungssysteme für Antennenelemente.

Die DE 10 2015 217 695 A1 offenbart eine Kommunikationsvorrichtung für ein Kraftfahrzeug. Die Kommunikationsvorrichtung umfasst eine Transceivereinheit und eine Antenne zum Aussenden von Sendesignalen der Transceivereinheit. Die Antenne ist mit der Transceivereinheit über ein Kabel gekoppelt. Um eine Signaldämpfung des Kabels bei den Sendesignalen zu kompensieren, ist eine Verstärkereinrichtung am antennenseitigen Ende des Kabels vorgesehen. Die Kommunikationseinrichtung kann beispielsweise für eine Car-to-Car-Kommunikation (Fahrzeug-zu-Fahrzeug-Kommunikation) vorgesehen sein.

Die US2007/129031 A offenbart ein Verfahren und eine Vorrichtung zur Verstärkungskalibrierung und insbesondere zur automatischen Kalibrierung in einer Transceiver-Einheit wie einem HiperLAN-Transceiver.

Diese technischen Lehren erfordern in nachteiliger Weise ebenfalls eine Datenübertragung eines Steuersignals zur Einstellung der Verstärkung von einer Signalbereitstellungseinheit zur Antenneneinheit.

Es stellt sich daher das technische Problem, eine selbstkalibrierende Antenneneinheit, ein Sendesystem mit einer solchen Antenneneinheit sowie ein Verfahren zum Betreiben einer Antenneneinheit zu schaffen, die einen effizienten und einfachen Betrieb der Antenneneinheit ermöglichen sowie Herstellungskosten für die Antenneneinheit reduzieren.

Die Lösung des technischen Problems ergibt sich durch die Gegenstände mit den Merkmalen der Ansprüche 1, 14 und 15. Weitere vorteilhafte Ausgestaltungen der Erfindung ergeben sich durch die Gegenstände mit den Merkmalen der Unteransprüche.

Vorgeschlagen wird ein Verfahren zum Betrieb einer Antenneneinheit. Die Antenneneinheit kann insbesondere zum Senden eines Signals dienen. Auch kann die Antenneneinheit zum Empfang eines Signals dienen. Das Signal kann insbesondere ein WLAN-Signal sein, weiter insbesondere ein Signal nach dem IEEE 802.11p-Standard. Hierbei können insbesondere Signale in einem Frequenzbereich von 5,8 GHz bis 5,9 GHz übertragen werden. Ebenfalls kann das Signal ein Mobilfunksignal sein, weiter insbesondere ein Mobilfunksignal nach dem Standard LTE-V2V (Long Term Evolution Vehicle to Vehicle) des europäischen ETSI 3GPP Norminstitut. Selbstverständlich ist es jedoch auch vorstellbar, andere Signale über die Antenneneinheit zu übertragen.

Die Antenneneinheit kann hierbei eine Antenneneinheit eines Fahrzeugs, insbesondere eines Kraftfahrzeugs, sein. Dies ist aber nicht zwingend. Auch in anderen technischen Anwendungsgebieten kann die Antenneneinheit eingesetzt werden, z.B. bei Schienenfahrzeugen oder in mobilen Endgeräten, zur Fernsteuerung von Fahrzeugen oder anderen Geräten oder sonstigen Anwendungsgebieten, in denen zur Signalübertragung Antenneneinheiten verwendet werden. Ist die Antenneneinheit in einem Kraftfahrzeug angeordnet, so kann diese insbesondere zur sogenannten Car2Car-Kommunikation dienen. Die Antenneneinheit kann hierbei im oder am Fahrzeug angeordnet sein, z.B. in einem Innenrückspiegel des Fahrzeugs, als eine Dachantenne ausgebildet sein oder in die Stoßfänger des Fahrzeugs integriert werden, insbesondere als verteilte Antenne.

Die Antenneneinheit weist eine antennenseitige Signalschnittstelle und eine geräteseitige Signalschnittstelle auf. An die antennenseitige Signalschnittstelle kann eine Antenne zum Senden und/oder Empfangen von Signalen angeschlossen werden oder sein. An die geräteseitige Signalschnittstelle kann eine Signalbereitstellungseinheit, z.B. eine Sende-/Empfangseinheit, insbesondere ein Modem, angeschlossen werden oder sein. Es ist möglich, dass die Antenneneinheit mit der Signalbereitstellungseinheit über ein Signalverbindungsmittel, z.B. ein Signalkabel, insbesondere ein Koaxialkabel, verbunden ist. Über das Kabel kann eine Signalübertragung erfolgen. Auch kann eine Energieversorgung der Antenneneinheit über das Kabel erfolgen. Bei der Übertragung über das Kabel können Kabelverluste auftreten.

Die Antenneneinheit kann hierbei zur Verstärkung von Sendesignalen, die von der Antenne gesendet bzw. ausgestrahlt werden, dienen. Alternativ oder vorzugsweise kumulativ kann die Antenneneinheit zur Verstärkung von Empfangssignalen, die von der Antenne empfangen werden, dienen.

Weiter umfasst die Antenneneinheit eine Steuereinrichtung, mindestens eine Einrichtung zur Einstellung einer Signalstärke eines Sendesignals und mindestens eine Einrichtung zur Erfassung einer Signalstärke des Sendesignals. Die Steuereinrichtung kann als Mikrocontroller ausgebildet sein oder einen solchen umfassen. Durch die Einrichtung zur Einstellung einer Signalstärke kann eine Signalstärke eines Sendesignals erhöht werden. Alternativ oder kumulativ kann die Signalstärke auch verringert werden. Die Einrichtung kann als Verstärkereinrichtung ausgebildet sein, insbesondere als eine Verstärkereinrichtung mit einstellbarem Verstärkungsfaktor. Vorzugsweise ist diese aber als Dämpfereinrichtung ausgebildet. Insbesondere ist die Einrichtung zur Einstellung der Signalstärke eine Einrichtung, deren Verstärkungs- und/oder Dämpfungsfaktor einstellbar ist und somit die Einstellung der Signalstärke auch unter konstanten Betriebsbedingungen ermöglicht.

Durch die Einrichtung zur Erfassung einer Signalstärke kann ein die Signalstärke repräsentierendes Signal erzeugt werden, z.B. ein Spannungssignal. Diese Einrichtung kann beispielsweise als Leistungsdetektor ausgebildet sein.

Mittels der Einrichtung zur Erfassung der Signalstärke kann insbesondere eine Signalstärke eines Signals erfasst werden, welches von der Einrichtung zur Einstellung der Signalstärke zur antennenseitigen Signalschnittstelle übertragen wird. Mit anderen Worten kann die Signalstärke eines verstärkten Signals erfasst werden. Allerdings ist es auch möglich, dass mittels der Einrichtung zur Erfassung der Signalstärke eine Signalstärke eines Signals erfasst werden kann, welches von der geräteseitigen Signalschnittstelle zur Einrichtung zur Einstellung der Signalstärke übertragen wird. Mit anderen Worten kann die Signalstärke eines unverstärkten Signals erfasst werden.

In einem Kalibriervorgang wird ein Kalibriersignal über die geräteseitige Signalschnittstelle empfangen. Das Kalibriersignal kann z.B. von der erläuterten Signalbereitstellungseinheit bereitgestellt, insbesondere erzeugt, werden. Das Kalibriersignal kann von der geräteseitigen Signalschnittstelle über die Einrichtung zur Einstellung der Signalstärke an die antennenseitige Signalschnittstelle übertragen werden.

Das Kalibriersignal kann hierbei ein Kommunikationssignal sein, wobei ein Kommunikationssignal Kommunikations- oder Nutzdaten enthalten kann. Insbesondere kann das Kalibriersignal ein moduliertes Signal sein. Vorzugsweise ist das Kalibriersignal ein moduliertes Signal mit einem geringen Crestfaktor, welcher das Verhältnis von Spitzenleistung zur mittlerer Leistung des Signals beschreibt. Dies ermöglicht eine einfache Bestimmung der Signalstärke des modulierten Signals. Auch kann das Kalibriersignal ein OFDM (Orthogonal Frequency-Division Multiplexing)-moduliertes Signal sein. Auch dies ermöglicht die Bestimmung der Signalstärke, wobei jedoch eine zeitliche Mittelung der Signalstärke über ein Zeitfenster vorbestimmter Dauer notwendig sein kann, um die Signalstärke zu bestimmen. Selbstverständlich kann das modulierte Signal auch gemäß einem anderen Modulationsverfahren moduliert sein.

Alternativ kann das Kalibriersignal kein Kommunikationssignal sein. Dieses kann insbesondere keine Kommunikations- oder Nutzdaten enthalten. So kann das Kalibriersignal z.B. ein unmoduliertes Signal, insbesondere ein so genanntes CW (Continuous wave)-Signal oder Trägersignal sein.

Das Kalibriersignal ist insbesondere ein Signal, dessen Signalstärke einfach, zuverlässig und genau bestimmt werden kann.

Weiter wird die Signalstärke des Kalibriersignals, insbesondere eines verstärkten Kalibriersignals, bestimmt. Die Signalstärke des verstärkten Kalibriersignals kann hierbei erfasst werden. Auch kann die Signalstärke eines verstärkten Kalibriersignals in Abhängigkeit einer Signalstärke eines Kalibriersignals bestimmt werden, die zwischen der geräteseitigen Signalschnittstelle und der antennenseitigen Signalschnittstelle erfasst wird, insbesondere in Abhängigkeit einer erfassten Signalstärke eines unverstärkten Kalibriersignals. Die Signalstärke kann eine Signalleistung sein. Insbesondere wird die Signalstärke des über die Einrichtung zur Einstellung der Signalstärke übertragenen Kalibriersignals bestimmt. Weiter wird die derart bestimmte Signalstärke mit einer Referenz-Signalstärke verglichen. Die Referenz-Signalstärke kann insbesondere eine vorbestimmte Signalstärke sein, z.B. eine vorbestimmte maximal zulässige Sendesignalstärke oder ein Anteil davon. Diese kann z.B. in einer Speichereinrichtung der Antenneneinheit abgespeichert sein. Die Referenz-Signalstärke kann z.B. eine vorbestimmte maximale Sendesignalstärke bzw. maximal gewünschte Sendesignalstärke sein und z.B. 23 dBm betragen.

Weiter wird, insbesondere mittels der Steuereinrichtung, ein Verstärkungsfaktor der mindestens einen Einrichtung zur Einstellung der Signalstärke derart eingestellt, dass die Differenz zwischen der Referenz-Signalstärke und die Signalstärke des verstärkten Kalibriersignals minimiert wird. Insbesondere kann der Verstärkungsfaktor der mindestens einen Einrichtung zur Einstellung der Signalstärke derart eingestellt werden, dass die Differenz zwischen der Referenz-Signalstärke und der bestimmten Signalstärke minimiert wird.

Insbesondere kann der Verstärkungsfaktor der mindestens einen Einrichtung zur Einstellung der Signalstärke derart eingestellt werden, dass die Differenz zwischen der Referenz-Signalstärke und einer Signalstärke eines verstärkten Kalibriersignals kleiner als ein vorbestimmter Schwellwert ist oder dass die Signalstärken gleich sind.

Das verstärkte Kalibriersignal kann ein über die Einrichtung zur Einstellung der Signalstärke übertragenes Kalibriersignal bezeichnen. Ein solches Signal liegt auf einer Signalverbindung zwischen der Einrichtung zur Einstellung der Signalstärke und der antennenseitigen Signalschnittstelle an. Insbesondere kann das verstärkte Kalibriersignal ein an der antennenseitigen Signalschnittstelle anliegendes Signal bezeichnen.

Der Verstärkungsfaktor kann ein Dämpfungsfaktor sein. Insbesondere kann der Verstärkungsfaktor derart eingestellt werden, dass ein Signal verstärkt oder geschwächt wird.

Weiter wird die Antenneneinheit nach Beendigung des Kalibriervorgangs mit dem derart eingestellten Verstärkungsfaktor betrieben.

Die Signalstärke des verstärkten Kalibriersignals kann hierbei - wie vorhergehend erläutert - erfasst werden, insbesondere mittels der Einrichtung zur Erfassung. Auch kann diese Signalstärke, insbesondere rechnerisch, bestimmt werden, insbesondere in Abhängigkeit eines unverstärkten Kalibriersignals. Ein unverstärktes Kalibriersignal kann ein nicht über die Einrichtung zur Einstellung der Signalstärke übertragenes Kalibriersignal bezeichnen und liegt hierbei zwischen der geräteseitigen Signalschnittstelle und der Einrichtung zur Einstellung der Signalstärke an. Beispielsweise kann eine Signalstärke eines unverstärkten Kalibriersignals bestimmt, insbesondere wie vorhergehend erläutert erfasst, werden und dann mit dem eingestellten oder einzustellenden Verstärkungsfaktor und gegebenenfalls Verstärkungsfaktoren weiterer Verstärkungseinrichtungen multipliziert werden, um die die Signalstärke des verstärkten Kalibriersignals zu bestimmen.

Es ist z.B. möglich, die Signalstärke des an der geräteseitigen Signalschnittstelle anliegenden unverstärkten Kalibriersignals und dann daraus die Signalstärke des verstärkten Kalibriersignals zu bestimmen.

Somit kann die Referenz-Signalstärke eine Signalstärke bezeichnen, die einen Referenzwert für die Signalstärke eines über die Einrichtung zur Einstellung der Signalstärke übertragenen und somit verstärkten Signals bildet, insbesondere für ein an der antennenseitigen Signalschnittstelle anliegendes Signal. Es ist aber auch vorstellbar, dass diese Referenz-Signalstärke - entsprechend den vorhergehenden Ausführungen - in Abhängigkeit eines Referenzwerts für die Signalstärke eines nicht über die Einrichtung zur Einstellung der Signalstärke übertragenen und somit unverstärkten Signals und des eingestellten oder einzustellenden Verstärkungsfaktors bestimmt wird, wobei der Referenzwert also einen Referenzwert für ein unverstärktes Signal bildet.

Die Antenneneinheit umfasst erfindungsgemäß mindestens einen Sendesignalzweig, wobei über den Sendesignalzweig ein Sendesignal von der geräteseitigen Signalschnittstelle an die antennenseitige Schnittstelle übertragen wird. Die Einrichtung zur Einstellung der Signalstärke kann im Sendesignalzweig angeordnet sein. Dies kann bedeuten, dass das Sendesignal von der geräteseitigen Signalschnittstelle über die Einrichtung an die antennenseitige Signalschnittstelle übertragen werden kann, wobei auch die Signalstärke des Sendesignals eingestellt, insbesondere verändert, werden kann. Weiter erfindungsgemäß ist die Einrichtung zur Erfassung der Signalstärke in dem Sendesignalzweig angeordnet.

Weiter kann die Antenneneinheit auch mindestens einen Empfangssignalzweig umfassen, wobei über den Empfangssignalzweig ein Empfangssignal von der antennenseitigen Signalschnittstelle an die geräteseitige Schnittstelle übertragen werden kann.

Zusätzlich zur der Einrichtung zur Einstellung der Signalstärke kann die Antenneneinheit mindestens eine Verstärkereinrichtung im Sendesignalzweig umfassen, insbesondere eine Konstantverstärkereinrichtung. Diese kann auch als Sendeverstärkereinrichtung bezeichnet werden.

Eine Konstantverstärkereinrichtung kann hierbei eine Verstärkereinrichtung bezeichnen, deren Verstärkungsfaktor nicht einstellbar ist, insbesondere nicht durch ein entsprechendes Steuersignal. Allerdings kann sich ein Verstärkungsfaktor einer Konstantverstärkereinrichtung bei einer Änderung von Betriebsbedingungen, z.B. bei Temperaturänderungen, verändern. Somit kann die Konstantverstärkereinrichtung eine Verstärkereinrichtung bezeichnen, deren Verstärkungsfaktor bei konstanten Betriebsbedingungen konstant ist und nicht verändert werden kann.

Alternativ ist es aber auch möglich, dass die Antenneneinheit als Sendeverstärkereinrichtung mindestens eine Verstärkereinrichtung mit einstellbarem Verstärkungsfaktor im Sendesignalzweig umfasst. Diese kann die Einrichtung zur Einstellung der Signalstärke ausbilden bzw. bereitstellen.

Auch kann die Antenneneinheit mindestens eine weitere Verstärkereinrichtung im Empfangssignalzweig umfassen. Auch diese weitere Verstärkereinrichtung kann eine Konstantverstärkereinrichtung oder eine Verstärkereinrichtung mit einstellbarem Verstärkungsfaktor sein. Diese kann auch als Empfangsverstärkereinrichtung bezeichnet werden. Insbesondere kann mittels der Einrichtung zur Erfassung der Signalstärke die Signalstärke des über die Einrichtung zur Einstellung der Signalstärke als auch über die Sendeverstärkereinrichtung übertragenen Kalibriersignals bestimmt werden.

Die Steuereinrichtung, die mindestens eine Einrichtung zur Einstellung einer Signalstärke eines Sendesignals und die mindestens eine Einrichtung zur Erfassung einer Signalstärke des Sendesignals können signaltechnisch verbunden sein.

Weiter kann die Antenneneinheit einen Temperatursensor zur Erfassung einer Temperatur der Antenneneinheit umfassen. Diese kann signaltechnisch mit der Steuereinrichtung verbunden sein. Weiter kann die Antenneneinheit einen Spannungssensor zur Erfassung einer Versorgungsspannungshöhe der Versorgungsspannung der Antenneneinheit umfassen. Diese kann signaltechnisch mit der Steuereinrichtung verbunden sein.

Der Kalibriervorgang kann eine Zeitdauer aus einem vorbestimmten Zeitdauerbereich, beispielsweise von 1ms bis 5ms, aufweisen. Der Kalibriervorgang kann in einem Kalibriermodus der Antenneneinheit durchgeführt werden. Dieser kann zur Durchführung des Kalibriervorgangs aktiviert werden. Nach Beendigung des Kalibriervorgangs kann ein Normalbetriebsmodus aktiviert werden. Dann wird im Normalbetriebsmodus der im Kalibriervorgang bestimmte Verstärkungsfaktor verwendet. Hierbei kann sich der Normalbetriebsmodus unmittelbar an den Kalibriermodus anschließen. Im Kalibriermodus dient die Antenneneinheit nicht zur bestimmungsgemäßen Signalübertragung von Sende- oder Empfangssignalen.

Durch das vorgeschlagene Verfahren ergibt sich in vorteilhafter Weise eine einfache und zuverlässige Kalibrierung des Verstärkungsfaktors und somit ein zuverlässiger Betrieb der Antenneneinheit, in dem Signalverluste bei der Übertragung eines Signals von der Signalbereitstellungseinheit an die Antenneneinheit kompensiert werden. Die Bestimmung und Einstellung des Verstärkungsfaktors erfolgt, insbesondere ausschließlich, durch die Antenneneinheit und benötigt keinen zusätzlichen Informationsaustausch mit der Signalbereitstellungseinheit. So müssen keine Informationen über eine Signalstärke, z.B. in Form von Daten, zwischen der Antenneneinheit und der Signalbereitstellungseinheit übertragen werden. Aufgrund des verringerten Bedarfs an Datenübertragung ergibt sich auch ein effizienterer Betrieb der Antenneneinheit. Da somit auch keine entsprechende Signalschnittstelle vorgesehen werden muss, können Herstellungskosten für die Antenneneinheit sowie die Signalbereitstellungseinheit reduziert werden. Auch wird eine einfache Nachrüstung einer Antenneneinheit ermöglicht, da diese nicht für eine entsprechende Kommunikation der Signalstärke mit der Signalbereitstellungseinheit ausgelegt sein muss. Ferner ergibt sich in vorteilhafter Weise, dass alternativ oder zusätzlich zu der Kompensation der übertragungsbedingten Signalverluste unerwünscht niedrige Signalstärken des von der Signalbereitstellungseinheit bereitgestellten Signals durch das vorgeschlagene Verfahren kompensiert werden können.

In einer weiteren Ausführungsform wird das Kalibriersignal von einer Signalbereitstellungseinheit erzeugt und über ein Signalverbindungsmittel über die geräteseitige Signalschnittstelle an die Antenneneinheit übertragen. Hierdurch ergibt sich in vorteilhafter Weise eine einfache Erzeugung des Kalibriersignals, da die Antenneneinheit auch im Normalbetrieb mit der Signalbereitstellungeinheit verbunden ist. Es ist hierbei also möglich, dass die Signalbereitstellungseinheit während des Kalibriervorgangs das notwendige Kalibriersignal erzeugt. Hierzu kann die Signalbereitstellungseinheit ebenfalls in einen Kalibriermodus versetzt werden, insbesondere simultan zur Antenneneinheit. Der Kalibriermodus beider Einheiten kann vorzugsweise gleichzeitig aktiviert werden, beispielsweise unmittelbar nach einem gleichzeitigen Einschalten oder Aktivieren beider Einheiten. Der Ablauf und die Art der durchgeführten Funktionen während des Kalibriermodus können hierbei in der entsprechenden Einheit, beispielsweise in einer Firmware, gespeichert sein.

In einer weiteren Ausführungsform erzeugt die Signalbereitstellungseinheit das Kalibriersignal mit der maximal erzeugbaren Signalstärke oder mit einer Signalstärke, die einem vorbestimmten Anteil der maximalen Signalstärke entspricht. Es ist hierbei möglich, dass Informationen über die Höhe des Anteils gespeichert sind, z.B. in einer Speichereinrichtung der Antenneneinheit.

Dies ermöglicht eine einfache Bestimmung der Referenz-Signalstärke, wobei diese insbesondere auf die antennenseitige Signalschnittstelle bezogen sein kann. Insbesondere kann nämlich, wenn das Kalibriersignal mit der von der Signalbereitstellungseinheit maximal erzeugbaren Signalstärke erzeugt wird, angenommen werden, dass die Antenneneinheit ein Sendesignal mit einer vorbestimmten (gewünschten) maximalen Sendesignalstärke erzeugen soll. Dies wiederum ermöglicht dann eine einfache Bestimmung des Verstärkungsfaktors. Entsprechendes gilt, wenn das Kalibriersignal mit einer anteiligen maximal erzeugbaren Signalstärke erzeugt wird.

In einer weiteren Ausführungsform wird die Referenz-Signalstärke, insbesondere ein auf die antennenseitige Signalschnittstelle bezogene Signalstärke, derart bestimmt, dass das Verhältnis von Referenz-Signalstärke zu der vorbestimmten maximalen Sendesignalstärke gleich dem Verhältnis von Signalstärke des von der Signalbereitstellungseinheit erzeugten Signals zur maximal erzeugbaren Signalstärke ist. Hierdurch ergibt sich in vorteilhafter Weise eine verbesserte Betriebssicherheit beim nachfolgenden Normalbetrieb der Antenneneinheit, da die Wahrscheinlichkeit einer unerwünschten Erzeugung von Sendesignalen mit zu hohen Signalstärken reduziert wird.

In einer weiteren Ausführungsform wird die maximal von der Signalbereitstellungseinheit erzeugbare Signalstärke des Kalibriersignals in Abhängigkeit der erfassten Signalstärke des Kalibriersignals bestimmt. Es ist z.B. möglich, dass verschiedenen Typen von Signalbereitstellungseinheiten existieren, die verschiedene maximale Signalstärken erzeugen können, z.B. 5 dBm oder 20 dBm. Daher kann es in einem solchen Kalibriervorgang erforderlich sein, dass die Antenneneinheit ermittelt, wie hoch die maximal erzeugbare Signalstärke einer an die Antenneneinheit angeschlossenen Signalbereitstellungseinheit ist. Insbesondere kann die Bestimmung in Abhängigkeit einer vorbekannten Zuordnung existieren, in der verschiedene Signalstärkenbereiche zu verschiedenen maximal erzeugbaren Signalstärken einer Signalbereitstellungseinheit zugeordnet sind. Diese Zuordnung kann beispielsweise in der Antenneneinheit abgespeichert sein.

Auch kann in Abhängigkeit der derart bestimmten maximal erzeugbaren Signalstärke und/oder der erfassten Signalstärke auch der vorhergehend erläuterte Anteil bzw. das vorhergehend erläuterte Verhältnis bestimmt werden. Hierfür kann, insbesondere für jede identifizierbare maximal erzeugbare Signalstärke, eine Zuordnung zwischen einem Anteil und einer Signalstärke des Kalibriersignals existieren, wobei in Abhängigkeit dieser Zuordnung der Anteil bestimmt werden kann.

Hierdurch ergibt sich in vorteilhafter Weise eine höhere Zuverlässigkeit und Genauigkeit bei der Kalibrierung, insbesondere wenn das Kalibriersignal von der Signalbereitstellungseinheit nicht mit der maximal erzeugbaren Signalstärke erzeugt wird.

In einer weiteren Ausführungsform wird ein Kalibriervorgang nach jedem Einschalten oder Aktivieren der Antenneneinheit durchgeführt. Mit anderen Worten kann der Kalibriermodus nach jedem Einschalten der Antenneneinheit aktiviert werden. Ein "Aktivieren" kann bedeuten, dass die Antenneneinheit aus einem nicht vollständig betriebsbereiten Zustand in einen vollständig betriebsbereiten Modus versetzt wird. Das Einschalten oder Aktivieren kann insbesondere erfolgen, wenn eine für den Normalbetrieb benötigte Energieversorgung der Antenneneinheit hergestellt wird.

Erfolgt eine solche Energieversorgung von der Signalbereitstellungseinheit, z.B. über das erläuterte Kabel, so kann das Einschalten oder Aktivieren der Signalbereitstellungseinheit gleichzeitig oder annähernd gleichzeitig zum Einschalten oder Aktivieren der Antenneneinheit führen. Hierdurch ergibt sich in vorteilhafter Weise, dass Einschalt- oder Aktivierungsvorgänge der Einheiten und somit auch die Aktivierung der entsprechende Kalibriermodi in zuverlässig synchronisiert werden können.

Ist die Antenneneinheit in einem Fahrzeug angeordnet, so kann das Einschalten oder Aktivieren der Antenneneinheit z.B. immer dann erfolgen, wenn der "Zündung ein"-Zustand des Fahrzeugs hergestellt wird.

In einer bevorzugten Ausführungsform ist die Einrichtung zur Einstellung der Signalstärke z.B. eine Dämpfereinrichtung. In diesem Fall ist der Verstärkungsfaktor ein Dämpfungsfaktor. Mit der Dämpfereinrichtung kann eine Signalstärke eines über die Dämpfereinrichtung übertragenen Signals verringert werden oder unverändert belassen werden, nicht jedoch erhöht werden. Hierdurch ergibt sich in vorteilhafter Weise eine einfache Herstellung einer Antenneneinheit. Insbesondere können existierende Antenneneinheiten ohne einstellbare Verstärkung, z.B. mit den vorhergehend erläuterten Konstantverstärkereinrichtungen, die regelmäßig als vorgefertigte und gewünschten Standards entsprechende Module existieren, nachgerüstet werden, um die Selbstkalibrierung zu ermöglichen.

Alternativ ist die Einrichtung zur Einstellung der Signalstärke eine Verstärkereinrichtung mit einem einstellbaren Verstärkungsfaktor.

In einer weiteren Ausführungsform ist durch die Einrichtung zur Einstellung der Signalstärke sowohl eine Signalstärke eines Sendesignals als auch eine Signalstärke eines Empfangssignals einstellbar oder veränderbar. Mit anderen Worten kann die Einrichtung zur Einstellung der Signalstärke sowohl im Sende- als auch im Empfangssignalzweig angeordnet sein. Hierdurch ergibt sich in vorteilhafter Weise eine ausbalancierte Verstärkung zwischen Sendesignal und Empfangssignal, wodurch z.B. Zulassungsvoraussetzungen erfüllt werden können. Es wird außerdem vermieden, dass durch die Antenneneinheit das Empfangssignal zu sehr verstärkt wird und die Signalbereitstellungseinheit mit einer zu hohen Signalleistung beaufschlagt wird.

In einer weiteren Ausführungsform wird eine Temperatur oder eine Temperaturänderung der Antenneneinheit bestimmt, wobei, insbesondere nach Beendigung des Kalibriervorgangs, der Verstärkungsfaktor der Einrichtung zur Einstellung der Signalstärke, insbesondere also der im Kalibriervorgang bestimmte Verstärkungsfaktor, in Abhängigkeit der Temperatur oder der Temperaturänderung verändert, also z.B. erhöht oder verringert, wird. Insbesondere kann der Verstärkungsfaktor derart temperaturabhängig geändert werden, dass eine temperaturbedingte Änderung der Gesamtverstärkung der Antenneneinheit minimiert oder vollständig kompensiert wird. Mit anderen Worten kann der Verstärkungsfaktor bei Temperaturänderungen der Antenneneinheit derart temperaturabhängig geändert werden, dass die Gesamtverstärkung der Antenneneinheit konstant oder annähernd konstant bleibt.

Es ist z.B. möglich, dass der Verstärkungsfaktor in Abhängigkeit eines vorbekannten Zusammenhangs zwischen einer Temperatur oder einer Temperaturänderung und einem Verstärkungsfaktor oder einer Veränderung des Verstärkungsfaktors eingestellt, insbesondere verändert, wird. Der vorbekannte Zusammenhang kann beispielsweise in Form einer Funktion oder einer Zuordnung, insbesondere in Form einer Kennlinie, gegeben sein.

Es ist insbesondere möglich, dass als Referenztemperatur eine Temperatur während des Kalibriervorgangs bestimmt wird, wobei der Verstärkungsfaktor dann in Abhängigkeit einer Differenz zwischen der Referenztemperatur und der aktuell bestimmten Temperatur verändert wird. So ist es z.B. möglich, dass der Verstärkungsfaktor in Abhängigkeit eines vorbekannten Zusammenhangs zwischen der Differenz und einem Verstärkungsfaktor oder einer Veränderung des Verstärkungsfaktors eingestellt, insbesondere verändert, wird. Auch dieser vorbekannte Zusammenhang kann beispielsweise in Form einer Funktion oder einer Zuordnung, insbesondere in Form einer Kennlinie, gegeben sein. Beispielsweise kann das Sendesignal umso mehr verstärkt werden, je kleiner der Wert der Differenz ist, wobei eine vorzeichenbehaftete Betrachtung erfolgt. Bei steigender Temperatur kann sich die Verstärkung der Verstärkereinrichtung für das Sendesignal verringern. Um die Gesamtverstärkung der Antenneneinheit über die Temperatur konstant zu halten, kann dann der Verstärkungsfaktor der Signaleinstelleinrichtung, also z.B. der Dämpfeinrichtung so verringert werden, dass die Gesamtverstärkung der Antenneneinheit konstant bleibt. Mit anderen Worten kann z.B. mit steigenden Temperaturen über der Referenztemperatur auch ein Signalverstärkungsfaktor erhöht werden.

Durch eine solche temperaturabhängige Einstellung des Verstärkungsfaktors kann erreicht werden, dass je nach Temperaturänderung die maximale Referenzleistung (z.B. 23dBm) der Antenneneinheit nicht überschritten oder unterschritten wird, wenn die Signalbereitstellungseinheit mit der maximalen Leistung sendet.

Hierdurch wird in vorteilhafter Weise eine Betriebsqualität der Antenneneinheit erhöht, insbesondere da temperaturbedingte Änderungen der Verstärkung vollständig oder zumindest teilweise kompensiert werden können.

In einer weiteren Ausführungsform wird eine Höhe der Versorgungsspannung der Antenneneinheit bestimmt. Die Versorgungsspannung kann insbesondere auch eine Versorgungspannung einer Konstantverstärkereinrichtung, z.B. der Sendeverstärkereinrichtung, sein. Weiter wird, insbesondere nach Beendigung des Kalibriervorgangs, der Verstärkungsfaktor der Einrichtung zur Einstellung der Signalstärke, insbesondere also der im Kalibriervorgang bestimmte Verstärkungsfaktor, in Abhängigkeit der Höhe der Versorgungsspannung verändert. Insbesondere kann der Verstärkungsfaktor derart versorgungsspannungsabhängig geändert werden, dass eine versorgungsspannungsbedingte Änderung der Gesamtverstärkung der Antenneneinheit minimiert oder vollständig kompensiert wird. Mit anderen Worten kann der Verstärkungsfaktor bei Änderungen der Versorgungsspannung der Antenneneinheit derart versorgungsspannungsabhängig geändert werden, dass die Gesamtverstärkung der Antenneneinheit konstant oder annähernd ist.

Es ist z.B. möglich, dass der Verstärkungsfaktor in Abhängigkeit eines vorbekannten Zusammenhangs zwischen der Versorgungspannungshöhe oder einer Änderung der Versorgungsspannungshöhe und einem Verstärkungsfaktor oder einer Veränderung des Verstärkungsfaktors eingestellt, insbesondere verändert, wird. Der vorbekannte Zusammenhang kann beispielsweise in Form einer Funktion oder einer Zuordnung, insbesondere in Form einer Kennlinie, gegeben sein.

Es ist insbesondere möglich, dass als Referenzversorgungsspannungshöhe eine Versorgungsspannungshöhe während des Kalibriervorgangs bestimmt wird, wobei der Verstärkungsfaktor in Abhängigkeit einer Differenz zwischen der Referenzversorgungsspannungshöhe und der aktuell bestimmten Versorgungsspannungshöhe verändert wird. Hierbei ist es z.B. möglich, dass der Verstärkungsfaktor in Abhängigkeit eines vorbekannten Zusammenhangs zwischen der Differenz und einem Verstärkungsfaktor oder einer Veränderung des Verstärkungsfaktors eingestellt, insbesondere verändert, wird. Der vorbekannte Zusammenhang kann beispielsweise in Form einer Funktion oder einer Zuordnung, insbesondere in Form einer Kennlinie, gegeben sein.

Insbesondere kann das Sendesignal umso mehr verstärkt werden, je kleiner der Wert der Differenz ist, wobei eine vorzeichenbehaftete Betrachtung erfolgt. So kann beispielsweise mit steigender Versorgungsspannungshöhe über der Referenzversorgungsspannung ein Signalverstärkungsfaktor verringert werden.

Hierdurch wird in vorteilhafter Weise eine Betriebsqualität der Antenneneinheit erhöht, insbesondere da versorgungsspannungsbedingte Änderungen der Verstärkung vollständig oder zumindest teilweise kompensiert werden können.

Erfindungsgemäß wird während des Kalibriervorgangs das verstärkte Kalibriersignal nicht an eine Antenne, insbesondere einen an die antennenseitige Signalschnittstelle angeschlossene Antenne, übertragen. Insbesondere kann das verstärkte Kalibriersignal in/an einen Antennen-Ersatzwiderstand eingespeist werden oder übertragen werden. Weiter kann in vorteilhafter Weise eine fehlerhafte Kalibrierung vermieden werden, die erfolgen würde, wenn äußere Einflüsse die Antenneneigenschaften verändern würden.

Hierzu kann der Antennen-Ersatzwiderstand an die antennenseitige Signalschnittstelle angeschlossen werden oder der Sendesignalzweig anstelle mit der antennenseitigen Signalschnittstelle mit dem Antennen-Ersatzwiderstand verbunden werden, z.B. über ein geeignetes Schaltmittel der Antenneneinheit.

Hierdurch ergibt sich in vorteilhafter Weise eine verbesserte Betriebssicherheit der Antenneneinheit, da im Kalibriervorgang die Antenne kein Signal sendet, welches z.B. den Betrieb weiterer Einheiten stören kann.

In einer weiteren Ausführungsform wird ein Sendemodus der Antenneneinheit aktiviert, wobei der Kalibriervorgang im Sendemodus durchgeführt wird. Insbesondere kann der Kalibriervorgang nur dann durchgeführt werden, wenn der Sendemodus aktiviert ist.
Der Sendemodus kann z.B. aktiviert werden, wenn ein Aktivierungssignal von der Antenneneinheit empfangen wird oder wenn ein Modussteuersignal einen vorbestimmten Signalpegel aufweist. Weiter kann auch ein Empfangsmodus aktiviert werden, z.B. wenn kein Aktivierungssignal empfangen wird oder das Modussteuersignal nicht den vorbestimmten Signalpegel aufweist. Im Sendemodus wird eine Signalverbindung zwischen der geräteseitigen Signalschnittstelle und der antennengeräteseitigen Signalschnittstelle über einen Sendesignalzweig hergestellt. Entsprechend wird im Empfangsmodus eine Signalverbindung zwischen der geräteseitigen Signalschnittstelle und der antennengeräteseitigen Signalschnittstelle über einen Empfangssignalzweig hergestellt.

Vorzugsweise wird das Aktivierungssignal oder Modussteuersignal von der Signalbereitstellungseinheit erzeugt und an die Antenneneinheit übertragen, z.B. über das vorhergehend erläuterte Signalverbindungsmittel. In der Antenneneinheit kann das Aktivierungssignal oder das Modussteuersignal aus dem übertragenen Signal extrahiert, z.B. herausgefiltert oder ausgekoppelt, werden. Das Aktivierungssignal oder Modussteuersignal kann Frequenzen aus einem Frequenzbereich aufweisen, die von Frequenzen des Kommunikationssignals verschieden sind, z.B. Frequenzen aus einem Bereich von 120 MHz bis 130 MHz. Somit kann der Kalibriervorgang z.B. nur dann durchgeführt werden, wenn die Signalbereitstellungseinheit ein entsprechendes Aktivierungssignal oder Modussteuersignal erzeugt. Es ist z.B. möglich, dass die Signalbereitstellungseinheit immer nach einem Einschalten oder Aktivieren ein entsprechendes Aktivierungssignal oder Modussteuersignal erzeugt.

Alternativ ist es auch möglich, dass für den Kalibriervorgang der Sendemodus unabhängig von dem Aktivierungs- oder Modussteuersignal aktiviert wird. Es ist z.B. möglich, dass die Antenneneinheit immer nach einem Einschalten oder Aktivieren den Sendemodus aktiviert.

Hierdurch ergibt sich in vorteilhafter Weise eine erhöhte Zuverlässigkeit bei der Durchführung der Kalibrierung.

Es ist weiter möglich, dass im Normalbetrieb der Antenneneinheit, also auch nach Beendigung des Kalibriervorgangs, der Sende- oder Empfangsmodus der Antenneneinheit mit dem Aktivierungssignal oder Modussteuersignal eingestellt wird, insbesondere von der Signalbereitstellungseinheit.

In einer weiteren Ausführungsform wird der Verstärkungsfaktor zu Beginn des Kalibriervorgangs in Abhängigkeit zumindest eines Verstärkungsfaktors bestimmt, der in einem vorhergehenden Kalibriervorgang bestimmt wurde. Es ist z.B. möglich, dass der in einem Kalibriervorgang bestimmte Verstärkungsfaktor gespeichert wird, z.B. in einer Speichereinrichtung der Antenneneinheit. Z.B. kann dann zu Beginn eines aktuellen Kalibriervorgangs der Verstärkungsfaktor auf den in einem, insbesondere im unmittelbar, vorhergehenden Kalibriervorgang gespeicherten Verstärkungsfaktor eingestellt werden.

Auch können die in allen oder einer vorbestimmten Anzahl von Kalibriervorgängen bestimmten Verstärkungsfaktoren gespeichert werden. Z.B. kann dann zu Beginn eines aktuellen Kalibriervorgangs der Verstärkungsfaktor auf einen Mittelwert dieser mehreren gespeicherten Verstärkungsfaktoren eingestellt werden.

Hierdurch ergibt sich in vorteilhafter Weise eine beschleunigte Bestimmung des Verstärkungsfaktors im Kalibriervorgang, da in der Regel davon ausgegangen werden kann, dass sich der Verstärkungsfaktor zwischen zwei Kalibriervorgängen, insbesondere zeitlich nah aufeinanderfolgenden Kalibriervorgängen, nicht oder nicht mehr als ein vorbestimmtes Maß ändert. Somit führt die Verwendung des vorhergehend bestimmten Verstärkungsfaktors als Startwert bei der Bestimmung regelmäßig schnell zur Bestimmung des aktuell gültigen Verstärkungsfaktors.

In einer weiteren Ausführungsform detektiert die Steuereinrichtung einen Fehlerzustand, wenn die minimierte Differenz größer als ein vorbestimmter Schwellwert ist. Wird ein Fehlerzustand detektiert, so kann ein Betriebsverhalten der Antenneneinheit, insbesondere durch die Steuereinrichtung verändert werden. Z.B. kann eine/können mehrere Konstantverstärkereinrichtungen deaktiviert werden. Auch kann die Verbindung zur Antennen unterbrochen werden. Auch kann eine Verbindung zum erläuterten Antennen-Ersatzwiderstand hergestellt werden. Dies ermöglicht es in vorteilhafter Weise, dass ein Fehler bei der Kalibrierung durch externe Einrichtungen, z.B. die Signalbereitstellungseinheit, detektierbar ist, ohne dass die Antenneneinheit Fehlerdaten übertragen muss. Beispielsweise kann die Signalbereitstellungseinheit eine Stromstärke eines über das Signalverbindungsmittel übertragenen Signals bestimmen und in Abhängigkeit der Stromstärke einen Fehlerzustand detektieren. Wird ein Fehler detektiert, so können beispielsweise geeignete Fehlermaßnahmen eingeleitet werden, z.B. die Ausgabe eines Fehlersignals an ein übergeordnetes System oder einen Nutzer.

An dieser Stelle ist anzumerken, dass auch ohne die Veränderung des Betriebsverhaltens der Antenneneinheit ein Fehlerzustand von einer externen Einrichtung detektierbar sein kann. So kann bereits ein Verstärkungsfaktor, der die erläuterte Differenz nicht auf Null oder ein vorbestimmtes Maß reduziert, dazu führen, dass sich ein Betriebsverhalten der Antenneneinheit derart einstellt, dass die Signalbereitstellungseinheit einen Fehlerzustand in Abhängigkeit der erläuterten Stromstärke detektiert.

In einer weiteren Ausführungsform wird, insbesondere nach Beendigung des Kalibriervorgangs, eine Signalstärke des Sendesignals bestimmt, wobei der Verstärkungsfaktor, insbesondere der im vorangegangenen Kalibriervorgang bestimmte Verstärkungsfaktor, in Abhängigkeit der Signalstärke verändert wird. Die Signalstärke kann durch die erläuterte Einrichtung zur Erfassung der Signalstärke erfasst werden. Weiter kann der Verstärkungsfaktor insbesondere derart eingestellt werden, dass ein vorbestimmter maximal zulässiger Grenzwert der Signalstärke nicht überschritten wird.

Hierdurch wird in vorteilhafter Weise eine Betriebssicherheit der Antenneneinheit erhöht.

Weiter vorgeschlagen wird eine selbstkalibrierende Antenneneinheit. Die Antenneneinheit ist hierbei gemäß einer der in dieser Offenbarung offenbarten Ausführungsformen ausgebildet.

In einem Kalibriervorgang ist ein Kalibriersignal über die geräteseitige Signalschnittstelle empfangbar, wobei die Signalstärke des Kalibriersignals, insbesondere eines verstärkten oder unverstärkten Kalibriersignals, bestimmbar ist, wobei die bestimmte Signalstärke, insbesondere die Signalstärke eines verstärkten Kalibriersignals, mit einer Referenz-Signalstärke vergleichbar ist, wobei ein Verstärkungsfaktor der mindestens einen Einrichtung zur Einstellung der Signalstärke derart einstellbar ist, dass die Differenz zwischen der Referenz-Signalstärke und der bestimmten Signalstärke, insbesondere einer Signalstärke des verstärkten Kalibriersignals, minimiert wird, wobei die Antenneneinheit nach Beendigung des Kalibriervorgangs mit dem derart eingestellten Verstärkungsfaktor betreibbar ist.

Somit ist die Antenneneinheit derart konfiguriert, dass ein Verfahren gemäß einer der in dieser Offenbarung beschriebenen Ausführungsformen mit der Antenneneinheit durchführbar ist.

Es ist möglich, aber nicht zwingend, dass die Antenneneinheit eine Schnittstelle zur Datenübertragung, z.B. zur Kommunikation, mit einer externen Einheit, insbesondere mit der Signalbereitstellungseinheit, umfasst. Über diese Schnittstelle können beispielsweise Diagnoseinformationen oder Informationen über Fehlerzustände übertragen werden. Die Schnittstelle ist aber insbesondere nicht dazu ausgebildet, Informationen über einen Verstärkungsfaktor von der Antenneneinheit an eine externe Einheit oder von einer externen Einheit an die Antenneneinheit zu übertragen. Selbstverständlich kann die Antenneneinheit aber auch derart ausgebildet sein, dass diese keine derartige Schnittstelle umfasst.

Weiter vorgeschlagen wird ein Sendesystem, umfassend eine selbstkalibrierende Antenneneinheit gemäß einer der in dieser Offenbarung beschriebenen Ausführungsformen sowie eine Signalbereitstellungseinheit, wobei die Antenneneinheit und die Signalbereitstellungseinrichtung über ein Signalverbindungsmittel verbunden sind. Dies und entsprechende Vorteile wurden vorhergehend bereits erläutert.

Es ist möglich, dass die Antenneneinheit und die Signalbereitstellungseinheit ausschließlich über das Signalverbindungsmittel verbunden sind, über welches ein von der Signalbereitstellungseinheit bereitgestelltes oder erzeugtes Signal an die Antenneneinheit zum Aussenden oder ein von der Antenneneinheit empfangenes Signal an die Signalbereitstellungseinheit übertragen wird. Insbesondere kann das System, weiter insbesondere die Elemente des Systems, derart konfiguriert sein, dass über das Signalverbindungsmittel keine Information über einen Verstärkungsfaktor zwischen den Einheiten übertragen wird.

Die Erfindung wird anhand von Ausführungsbeispielen näher erläutert. Die Figuren zeigen:
- Fig. 1: ein schematisches Blockschaltbild eines erfindungsgemäßen Sendesystems gemäß einer ersten Ausführungsform,
- Fig. 1a: ein schematisches Blockschaltbild eines erfindungsgemäßen Sendesystems gemäß einer weiteren Ausführungsform,
- Fig. 2: ein schematisches Blockschaltbild eines erfindungsgemäßen Sendesystems gemäß einer weiteren Ausführungsform,
- Fig. 3: ein schematisches Blockschaltbild eines erfindungsgemäßen Sendesystems gemäß einer weiteren Ausführungsform,
- Fig. 4: ein schematisches Flussdiagramm eines erfindungsgemäßen Verfahrens und.
- Fig. 5: ein schematisches Blockschaltbild eines erfindungsgemäßen Sendesystems gemäß einer weiteren Ausführungsform.

Nachfolgend bezeichnen gleiche Bezugszeichen Elemente mit gleichen oder ähnlichen technischen Merkmalen.

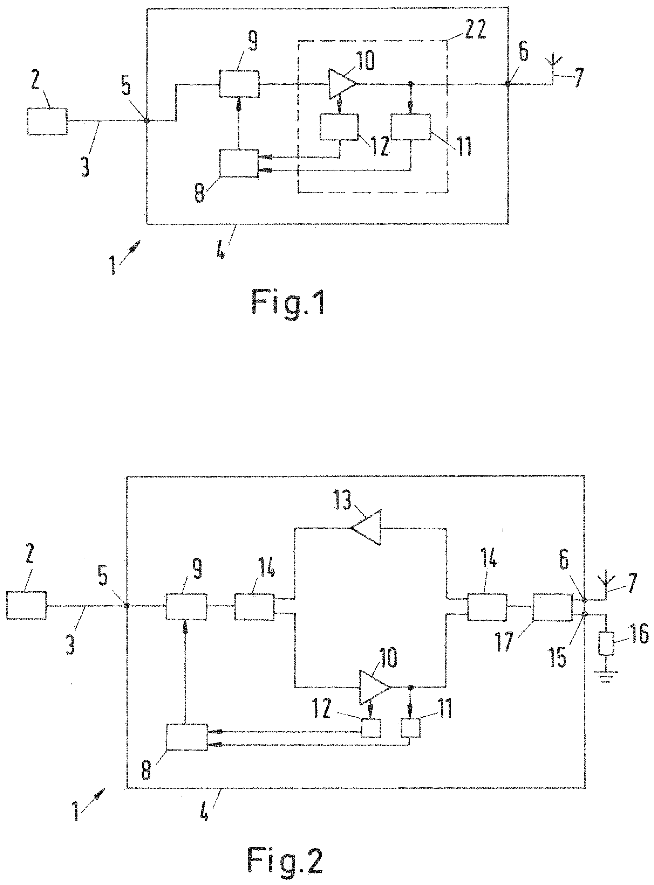

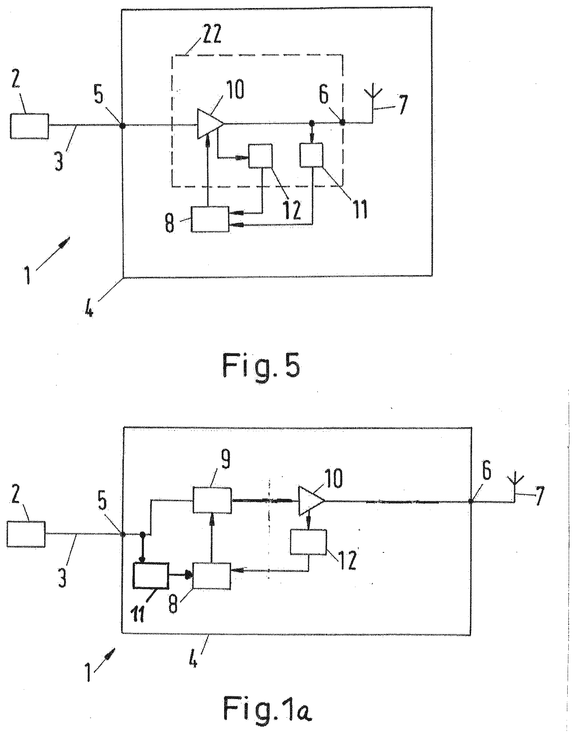

Fig. 1 zeigt ein schematisches Blockschaltbild eines erfindungsgemäßen Sendesystems 1. Das Sendesystem 1 umfasst eine Signalbereitstellungseinheit 2, die beispielsweise als Modem ausgebildet sein kann. Insbesondere kann die Signalbereitstellungseinheit 2 als Sende-/Empfangseinheit ausgebildet sein. Diese kann zum Senden und Empfangen von WLAN-Signalen dienen, insbesondere von WLAN-Signalen gemäß dem IEEE 802.11p-Standard oder den Mobilfunksignalen nach dem Standard LTE-V2V (Long Term Evolution Vehicle to Vehicle) des europäischen ETSI 3GPP Norminstitut. Die Sende-/Empfangseinheit 2 ist über ein als Koaxialkabel 3 ausgebildetes Signalverbindungsmittel mit einer erfindungsgemäßen Antenneneinheit 4 verbunden. Die Antenneneinheit 4 umfasst eine geräteseitige Signalschnittstelle 5, über die die Antenneneinheit 4 mittels des Koaxialkabels 3 mit der Sende-/Empfangseinheit 2 verbunden ist. Weiter umfasst die Antenneneinheit 4 eine antennenseitige Signalschnittstelle 6. Über die antennenseitige Signalschnittstelle 6 kann eine Antenne 7 an die Antenneneinheit 4 angeschlossen werden. Es ist hierbei möglich, dass die Antenneneinheit 4 auch die Antenne 7 umfasst. So können z.B. Elemente der Antenneneinheit 4 als auch die Antenne 7 auf einer gemeinsamen Leiterplatte angeordnet sein. Dies ist aber nicht zwingend.

Weiter umfasst die Antenneneinheit 4 eine Steuereinrichtung 8. Diese Steuereinrichtung 8 kann als Mikrocontroller ausgebildet sein oder einen Mikrocontroller umfassen. Weiter umfasst die Antenneneinheit 4 eine als Dämpfereinrichtung 9 ausgebildete Einrichtung zur Einstellung bzw. Veränderung einer Signalstärke eines Sendesignals. Ein Sendesignal wird hierbei von der Signalbereitstellungseinheit 2 erzeugt und über das Koaxialkabel 3 sowie über die geräteseitige Signalschnittstelle 5 an die Antenneneinheit 4 übertragen. Weiter wird das Sendesignal von der geräteseitigen Signalschnittstelle 5 über die Dämpfereinrichtung 9 und eine auch als Sendeverstärkereinrichtung bezeichnete Verstärkereinrichtung 10 der Antenneneinheit 4 an die antennenseitige Signalschnittstelle 6 und von dort an die Antenne 7 übertragen. Die Sendeverstärkereinrichtung 10 kann als Konstantverstärkereinrichtung ausgebildet sein. Somit umfasst die Antenneneinheit 4 auch die Sendeverstärkereinrichtung 10. Sowohl die Dämpfereinrichtung 9 als auch die Konstantverstärkereinrichtung 10 sind in einem Sendesignalzweig der Antenneneinheit 4 angeordnet.

Weiter umfasst die Antenneneinheit eine als Leistungsdetektor 11 ausgebildete Einrichtung zur Erfassung einer Signalstärke eines Sendesignals. Dargestellt ist, dass der Leistungsdetektor 11 die Signalstärke eines Signals erfasst, welches von der Konstantverstärkereinrichtung 10 an die antennenseitige Signalschnittstelle 6 übertragen wird, also eines verstärkten Signals. Der Leistungsdetektor 11 kann beispielsweise ein Spannungssignal erzeugen, welches die Signalstärke bzw. eine Signalleistung des Sendesignals repräsentiert, insbesondere proportional dazu ist. Der Leistungsdetektor 11 ist hierbei mit der Steuereinrichtung 8 signaltechnisch verbunden.

Weiter dargestellt ist, dass die Antenneneinheit 4 einen Temperatursensor 12 zur Erfassung einer Temperatur der Antenneneinheit 4 umfasst. Dieser Temperatursensor 12 ist ebenfalls signaltechnisch mit der Steuereinrichtung 8 verbunden.

Es ist möglich, dass eine Sendeverstärkereinrichtung 10 mit einem Leistungsdetektor 11 und einem Temperatursensor 12 als ein integrierter Schaltkreis 22 ausgeführt ist. Diese gemeinsame Ausführung wird durch einen mit Strichlinien dargestellten Block visualisiert und kann auch als Front-End-Modul bezeichnet werden.

Die Dämpfereinrichtung 9 kann eine sogenannte variable Dämpfereinrichtung sein. Insbesondere kann die Dämpfereinrichtung 9 als digitale Dämpfereinrichtung (digital attenuator) ausgebildet sein. Die Dämpfereinrichtung 9 ist signaltechnisch mit der Steuereinrichtung 8 verbunden. Die Steuereinrichtung 8 kann hierbei einen Dämpfungsfaktor der Dämpfereinrichtung 9 einstellen. Mittels der Dämpfereinrichtung 9 kann eine Signalstärke des von der geräteseitigen Signalschnittstelle 5 an die Dämpfereinrichtung 9 übertragenen Sendesignals verringert werden, insbesondere wenn der Dämpfungsfaktor größer als 1 ist. Auch kann die Signalstärke unverändert belassen werden, insbesondere wenn der Dämpfungsfaktor 1 beträgt. Eine Verstärkung dieses Signals mittels der Dämpfereinrichtung 9 ist nicht möglich.

Die dargestellte Antenneneinheit 4 bildet eine selbstkalibrierende Antenneneinheit 4. In einem Kalibriervorgang der Antenneneinheit 4 kann ein Dämpfungsfaktor bestimmt werden, wobei dieser Dämpfungsfaktor von der Steuereinrichtung 8 für den Betrieb (Normalbetrieb) der Antenneneinheit 4 nach Beendigung des Kalibriervorgangs verwendet wird. Der Dämpfungsfaktor kann hierbei von der Steuereinrichtung 8 in Abhängigkeit des Ausgangssignals des Leistungsdetektors 11 bestimmt werden.

Es ist möglich, dass eine Energieversorgung der Antenneneinheit 4 durch die Signalbereitstellungseinheit 2 erfolgt, wobei die entsprechende Energie über das Koaxialkabel 3 übertragen wird.

Ein Kalibriervorgang kann hierbei beispielsweise unmittelbar nach jedem Einschalten oder Aktivieren der Antenneneinheit 4 durchgeführt werden. Erfolgt die Energieversorgung durch die Signalbereitstellungseinheit 2, so kann der Kalibriervorgang nach jedem Einschalten oder Aktivieren der Signalbereitstellungseinheit 2 durchgeführt werden, da in diesem Fall die Antenneneinheit 4 immer dann eingeschaltet oder aktiviert wird, wenn auch die Signalbereitstellungseinheit 2 eingeschaltet oder aktiviert wird.

In einem Kalibriervorgang wird von der Antenneneinheit 4 ein Kalibriersignal über die geräteseitige Signalschnittstelle 5 empfangen. Das Kalibriersignal kann hierbei von der Signalbereitstellungseinheit 2 erzeugt werden. Es ist z.B. möglich, dass auch die Signalbereitstellungseinheit 2 nach jedem Einschalten oder Aktivieren einen Kalibriervorgang durchführt bzw. an dem Kalibriervorgang der Antenneneinheit 4 teilnimmt, z.B. indem die Signalbereitstellungseinheit 2 unmittelbar nach dem Einschalten oder Aktivieren das Kalibriersignal erzeugt. Eine entsprechende Funktionalität der Signalbereitstellungseinheit 2 kann beispielsweise bereitgestellt werden, indem die entsprechende Funktionalität in der Firmware der Signalbereitstellungseinheit 2 kodiert wird.

Vorzugsweise erzeugt die Signalbereitstellungseinheit 2 als Kalibriersignal ein Signal mit der maximal von der Signalbereitstellungseinheit 2 erzeugbaren Signalstärke. Diese kann beispielsweise 5 dBm oder 20 dBm betragen.

Weiter wird in dem Kalibriervorgang die Signalstärke des über die Dämpfereinrichtung 9 und die Sendeverstärkereinrichtung 10 übertragenen und somit verstärkten Kalibriersignals bestimmt. Dies kann mittels des Leistungsdetektors 11 und der Steuereinrichtung 8 erfolgen.

Weiter wird die derart bestimmte Signalstärke mit einer Referenz-Signalstärke verglichen, insbesondere ebenfalls durch die Steuereinrichtung 8. Die Referenz-Signalstärke kann beispielsweise eine vorbestimmte maximale Sendesignalstärke sein, die von der Antenneneinheit 4 für ein von der antennenseitigen Signalschnittstelle 6 an die Antenne 7 übertragenes Sendesignal eingestellt werden soll. Eine solche vorbestimmte maximale Sendesignalstärke kann beispielsweise 23 dBm betragen. Selbstverständlich ist es jedoch auch möglich, andere vorbestimmte maximale Sendesignalstärken zu wählen. Es ist möglich, dass die Referenz-Signalstärke gespeichert ist, beispielsweise in einer nicht in Fig. 1 dargestellten Speichereinrichtung der Antenneneinheit 4, oder einer internen Speichereinrichtung der Steuereinrichtung 8, z.B. einen Speicher in einem Mikrocontroller.

Weiter wird mittels der Steuereinrichtung 8 der Dämpfungsfaktor der Dämpfungseinrichtung 9 derart eingestellt, dass die Differenz zwischen der Referenz-Signalstärke und der bestimmten Signalstärke des Kalibriersignals minimiert wird. Vorzugsweise wird der Dämpfungsfaktor derart eingestellt, dass die Differenz 0 beträgt oder nicht mehr als ein vorbestimmtes Maß von 0 abweicht.

Nach Beendigung des Kalibriervorgangs wird dann die Antenneneinheit 4, insbesondere die Dämpfereinrichtung 9, mit dem derart bestimmten Dämpfungsfaktor betrieben. Auch ist es möglich, den in einem Kalibriervorgang bestimmten Dämpfungsfaktor zu speichern, beispielsweise ebenfalls in der vorhergehend erläuterten Speichereinrichtung oder in einer weiteren Speichereinrichtung. Insbesondere in diesem Fall ist es möglich, dass der Dämpfungsfaktor zu Beginn eines neuen Kalibriervorgangs in Abhängigkeit eines Dämpfungsfaktors eingestellt wird, der in einem vorhergehenden Kalibriervorgang bestimmt wurde.

Der beschriebene Kalibriervorgang ermöglicht in vorteilhafter Weise durch das Koaxialkabel bedingte Signalverluste zu kompensieren, ohne dass eine zusätzliche Signalübertragung zwischen der Antenneneinheit 4 und der Signalbereitstellungseinheit 2 notwendig ist. Anschaulich gesprochen wird unter der Annahme, dass in einem Kalibriervorgang von der Signalbereitstellungseinheit 2 die maximal erzeugbare Signalstärke bereitgestellt wird, der Dämpfungsfaktor derart bestimmt, dass eine vorbestimmte, gewünschte maximale Sendesignalstärke von der Antenneneinheit 4 an der antennenseitigen Signalschnittstelle 6 bereitgestellt wird. Somit kann davon ausgegangen werden, dass der Dämpfungsfaktor derart bestimmt wird, dass die durch das Koaxialkabel 3 bedingten Kabelverluste kompensiert werden. Da die Kabelverluste nicht signalstärkeabhängig sind, sorgt der derart eingestellte Dämpfungsfaktor auch in einem nach dem Kalibriervorgang erfolgenden Normalbetrieb für eine zuverlässige und genaue Kompensation der Kabelverluste, insbesondere auch für Signalstärken, die von der maximal erzeugbaren Signalstärke der Signalbereitstellungseinheit 2 abweichen.

Es ist allerdings auch möglich, dass die Signalbereitstellungseinheit 2 in einem Kalibriervorgang ein Kalibriersignal nicht mit der maximal erzeugbaren Signalstärke, sondern mit einer Signalstärke erzeugt, die einem vorbestimmten Anteil der maximal erzeugbaren Signalstärke entspricht. Informationen, insbesondere ein numerischer Wert dieses Anteils, können vorbestimmt sein. Diese Informationen können gespeichert sein, beispielsweise ebenfalls in der vorgehergehend erläuterten Speichereinrichtung der Antenneneinheit 4.

In diesem Fall kann als Referenz-Signalstärke ein Anteil der vorbestimmten maximalen Sendesignalstärke gewählt werden. Bei einem solchen Kalibriervorgang kann es allerdings erforderlich sein, dass die Antenneneinheit 4 ermittelt, wie hoch die maximal erzeugbare Signalstärke einer an die Antenneneinheit 4 angeschlossenen Signalbereitstellungseinheit 2 ist. Es kann nämlich angenommen werden, dass verschiedene Signalbereitstellungseinheiten 2 voneinander verschiedene maximal erzeugbare Signalstärken erzeugen können. Die Bestimmung bzw. Identifikation der maximal erzeugbaren Signalstärke kann hierbei in Abhängigkeit der während des Kalibriervorgangs bestimmten Signalstärke des Kalibriersignals erfolgen. So kann beispielsweise eine Zuordnung existieren, in der verschiedene Signalstärkenbereiche verschiedenen maximal erzeugbaren Signalstärken einer Signalbereitstellungseinheit 2 zugeordnet sind. Diese Zuordnung kann beispielsweise in der Antenneneinheit 4, insbesondere in einer der vorhergehend erläuterten Speichereinrichtungen, abgespeichert sein. In Abhängigkeit dieser Zuordnung kann dann die maximal erzeugbare Signalstärke der Signalbereitstellungseinheit 2 bestimmt werden. Ist z.B. bekannt, dass verschiedene Typen von Signalbereitstellungseinheiten 2 entweder eine maximal erzeugbare Signalstärke von 5 dBm oder von 20 dBm erzeugen können, so kann davon ausgegangen werden, dass bei Signalstärken des Kalibriersignals kleiner als 5 dBm die maximal von der Signalbereitstellungseinheit 2 erzeugbare Signalstärke 5 dBm beträgt, wobei bei Signalstärken des Kalibriersignals größer als 5 dBm die maximal von der Signalbereitstellungseinheit 2 erzeugbare Signalstärke 20 dBm beträgt.

Weiter kann in Abhängigkeit der derart bestimmten maximal erzeugbaren Signalstärke auch der entsprechende Anteil bestimmt werden. Hierfür kann, insbesondere für jede identifizierbare maximal erzeugbare Signalstärke, eine Zuordnung zwischen einem Anteil und einer Signalstärke des Kalibriersignals existieren, wobei in Abhängigkeit dieser Zuordnung der Anteil bestimmt werden kann.

Es ist weiter möglich, dass während des Kalibriervorgangs die Temperatur der Antenneneinheit 4 bestimmt wird, insbesondere mittels des Temperatursensors 12. Diese kann beispielsweise gespeichert werden, insbesondere in einer der vorhergehend erläuterten Speichereinrichtungen.

Nach Beendigung des Kalibriervorgangs, insbesondere in einem Normalbetrieb der Antenneneinheit 4, kann dann fortlaufend mittels des Temperatursensors 12 die Temperatur der Antenneneinheit 4 bestimmt werden. Weiter kann der Dämpfungsfaktor in Abhängigkeit der Differenz zwischen der aktuell erfassten Temperatur und der während des vorhergehenden Kalibriervorgangs erfassten Temperatur eingestellt, insbesondere verändert werden. Beispielsweise kann der Dämpfungsfaktor bei Temperaturen, die höher als die Temperatur des Kalibriervorgangs sind, umso niedriger eingestellt werden, je höher die besagte Differenz ist.

Nicht in Fig. 1 dargestellt ist, dass auch eine Versorgungsspannungshöhe der Antenneneinheit 4, insbesondere eine Versorgungsspannungshöhe der Sendeverstärkereinrichtung 10, bestimmt werden kann. Hierzu kann die Antenneneinheit 4 einen nicht in Fig. 1 dargestellten Spannungssensor umfassen. Hierbei kann die Versorgungsspannungshöhe während des Kalibriervorgangs bestimmt werden. Diese kann beispielsweise gespeichert werden, insbesondere in einer der vorhergehend erläuterten Speichereinrichtungen.

Weiter kann im Normalbetrieb die Versorgungsspannungshöhe fortlaufend erfasst werden. Weiter kann der Dämpfungsfaktor in Abhängigkeit einer Differenz zwischen der aktuell erfassten Versorgungsspannungshöhe und der während des Kalibriervorgangs erfassten Versorgungsspannungshöhe eingestellt werden. Liegt z.B. die aktuell erfasste Versorgungsspannungshöhe unter der während des Kalibriervorgangs erfassten Versorgungsspannungshöhe, so kann der Dämpfungsfaktor mit steigender Differenz bzw. mit steigendem Betrag der Differenz verringert werden.

Es ist weiter möglich, dass fortlaufend auch die Signalstärke des Sendesignals bestimmt wird, insbesondere mittels des Leistungsdetektors 11. Überschreitet die mittels des Leistungsdetektors 11 erfasste Signalstärke eine vorbestimmte, maximal zulässige Signalstärke, so kann insbesondere mittels der Steuereinrichtung 8, der Dämpfungsfaktor der Dämpfereinrichtung 9 derart eingestellt werden, dass die Sendesignalstärke auf die maximal zulässige Sendesignalstärke eingestellt und somit begrenzt wird. Hierdurch wird in vorteilhafter Weise erreicht, dass kein unerwünschter Betriebszustand der Antenneneinheit 4 eintritt und keine erwünscht hohe Sendeleistung dauerhaft von der Antenneneinheit 4 ausgesendet wird.

Mit anderen Worten wird eine Selbstkalibrierung der Antenneneinheit 4 ermöglicht. Während des Kalibriervorgangs wird ein Dämpfungsfaktor, der exemplarisch für einen Verstärkungsfaktor angeführt wird, bestimmt, wobei dieser für den auf den Kalibriervorgang folgenden Normalbetrieb eingestellt wird. Dieser Dämpfungsfaktor ist idealerweise im Normalbetrieb konstant. Um jedoch Veränderungen des Verstärkungsverhaltens der Antenneneinheit 4 während des Normalbetriebs zu kompensieren, die temperatur- und/oder versorgungsspannungsbedingt sind, kann der durch die Selbstkalibration bestimmte Dämpfungsfaktor auch während des Normalbetriebs verändert werden. Ebenfalls kann der Dämpfungsfaktor im Normalbetrieb verändert werden, um die maximal erzeugte Sendesignalstärke auf eine maximal zulässige Sendesignalstärke zu begrenzen.

Fig. 1a zeigt ein schematisches Blockschaltbild eines erfindungsgemäßen Sendesystems 1 in einer weiteren Ausführungsform. Das in Fig. 1a dargestellte Sendesystem 1 ist hierbei im Wesentlichen wie das in Fig. 1 dargestellte Sendesystem 1 ausgebildet. Daher kann auf die entsprechenden Ausführungen zu Fig. 1 verwiesen werden. Im Unterschied zu Fig. 1 erfasst der Leistungsdetektor 11 die Signalstärke eines Signals, welches von der geräteseitigen Signalschnittstelle 5 an die Dämpfereinrichtung 9 übertragen wird, also eines unverstärkten Signals.

Weiter wird in einem Kalibriervorgang die Signalstärke des von der geräteseitigen Signalschnittstelle 5 an die Dämpfereinrichtung 9 übertragenen (unverstärkten) Kalibriersignals bestimmt. Dies kann mittels des Leistungsdetektors 11 und der Steuereinrichtung 8 erfolgen. Weiter wird, insbesondere mittels der Steuereinrichtung 8, eine Signalstärke des verstärkten Kalibriersignals bestimmt, indem die erfasste Signalstärke mit den aktuell eingestellten Verstärkungsfaktoren der Dämpfereinrichtung 9 und der Konstantverstärkereinrichtung 10 multipliziert wird.

Weiter wird die derart bestimmte Signalstärke des verstärkten Kalibriersignals mit einer Referenz-Signalstärke verglichen, insbesondere ebenfalls durch die Steuereinrichtung 8.

Weiter wird mittels der Steuereinrichtung 8 der Dämpfungsfaktor der Dämpfungseinrichtung 9 derart eingestellt, dass die Differenz zwischen der Referenz-Signalstärke und der wie erläutert bestimmten Signalstärke des verstärkten Kalibriersignals minimiert wird. Vorzugsweise wird der Dämpfungsfaktor derart eingestellt, dass die Differenz 0 beträgt oder nicht mehr als ein vorbestimmtes Maß von 0 abweicht.

Nach Beendigung des Kalibriervorgangs wird dann die Antenneneinheit 4, insbesondere die Dämpfereinrichtung 9, mit dem derart bestimmten Dämpfungsfaktor betrieben.

Fig. 2 zeigt ein Blockschaltbild eines erfindungsgemäßen Sendesystems 1 in einer weiteren Ausführungsform. Hierbei kann auf die Erläuterungen zu Fig. 1 verwiesen werden. Im Unterschied zu der in Fig. 1 dargestellten Ausführungsform ist zusätzlich zu dem vorhergehend erläuterten Sendesignalzweig auch ein Empfangssignalzweig dargestellt. Über den Empfangssignalzweig kann ein von der Antenne 7 empfangenes Signal über die antennenseitige Signalschnittstelle 6 an die Antenneneinheit 4 übertragen werden. Die Antenneneinheit 4 umfasst hierbei eine auch als Empfangsverstärkereinrichtung bezeichnete weitere Verstärkereinrichtung 13 zur Verstärkung eines solchen Empfangssignals, die als Konstantverstärkereinrichtung ausgebildet sein kann. Weiter dargestellt ist, dass die Antenneneinheit 4 Schaltmittel 14 zur Herstellung von Signalverbindungen über einen Sendesignalzweig oder den Empfangssignalzweig umfasst. In einem Sendemodus sind die Schaltmittel 14 hierbei derart angesteuert, dass ein Sendesignal von der geräteseitigen Signalschnittstelle 5 über die Dämpfereinrichtung 9 und die Sendeverstärkereinrichtung 10 an die antennenseitige Signalschnittstelle 6 übertragen wird. In einem Empfangsmodus können die Schaltmittel 14 derart angesteuert sein, dass eine Signalverbindung von der antennenseitigen Signalschnittstelle 6 über die Empfangsverstärkereinrichtung 13 sowie die Dämpfereinrichtung 9 zur geräteseitigen Signalschnittstelle 5 hergestellt ist.

Die Schaltmittel 14 können hierbei von der Steuereinrichtung 8 gesteuert werden.

Weiter dargestellt ist, dass die Antenneneinheit 4 eine widerstandsseitige Signalschnittstelle 15 umfasst, an die ein Antennen-Ersatzwiderstand 16 angeschlossen ist. Weiter umfasst die Antenneneinheit 4 ein weiteres Schaltmittel 17. Mittels des weiteren Schaltmittels 17 kann ein Signalausgang der Sendeverstärkereinrichtung 10 entweder mit der antennenseitigen Signalschnittstelle 6 oder der widerstandsseitigen Signalschnittstelle 15 verbunden werden. Das weitere Schaltmittel 17 kann hierbei ebenfalls von der Steuereinrichtung 8 gesteuert werden.

Während des Kalibriervorgangs kann das weitere Schaltmittel 17 insbesondere derart angesteuert werden, dass der Signalausgang der Sendeverstärkereinrichtung 10 zur Verstärkung des Sendesignals (und somit des Kalibriersignals) über den Ersatzwiderstand 16 mit einem Referenz- oder Massepotential verbunden wird. Hierdurch wird in vorteilhafter Weise erreicht, dass während des Kalibriervorgangs von der Antenne 7 kein Sendesignal ausgesendet wird, welches ein unerwünschtes Störsignal bilden kann.

Weiter ist in Fig. 2 dargestellt, dass die Dämpfereinrichtung 9 sowohl im Sendesignalzweig als auch im Empfangssignalzweig angeordnet ist. Somit bildet der während des Kalibriervorgangs bestimmte Dämpfungsfaktor dann im Normalbetrieb sowohl den im Sendebetrieb eingestellten Dämpfungsfaktor als auch den im Empfangsbetrieb der Antenneneinheit 4 eingestellten Dämpfungsfaktor. Hierdurch ergibt sich in vorteilhafter Weise eine einfache Herstellung der selbstkalibrierenden Antenneneinheit 4, da die Einheit aus Sendeverstärkereinrichtung 10, Leistungsdetektor 11 und Temperatursensor 12 und gegebenenfalls der Empfangsverstärkereinrichtung 13 sowie den Schaltmitteln 14 in der Regel als vorgefertigtes Modul vorliegt und somit eine einfache Erweiterung der Antenneneinheit 4 möglich ist. Weiter ergibt sich in vorteilhafter Weise, dass eine annähernd gleiche Verstärkung in Sende- und Empfangszweig erfolgt.

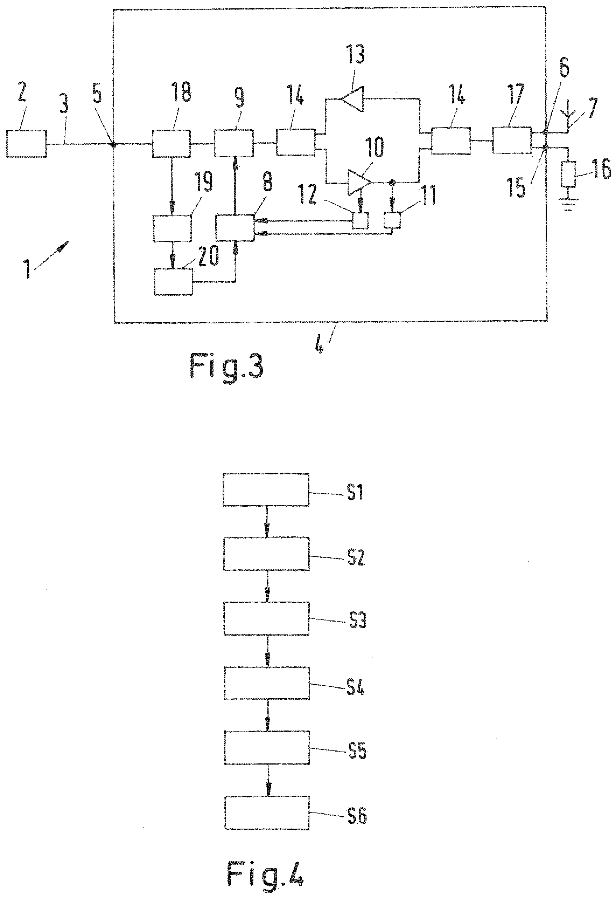

Fig. 3 zeigt ein weiteres schematisches Blockschaltbild eines erfindungsgemäßen Sendesystems 1 in einer weiteren Ausführungsform. Die Antenneneinheit 4 des Sendesystems 1 ist hierbei im Wesentlichen wie die in Fig. 2 dargestellte Antenneneinheit 4 ausgebildet. Daher kann auf die entsprechenden Ausführungen zu Fig. 2 verwiesen werden. Im Unterschied zu der in Fig. 2 dargestellten Antenneneinheit 4 umfasst die Antenneneinheit 4 ein Signalauskopplungsmittel 18, welches in einem Signalzweigabschnitt zwischen der geräteseitigen Signalschnittstelle 5 und der Dämpfereinrichtung 9 angeordnet ist. Mittels des Signalauskopplungsmittels 18 kann ein Signalanteil mit einer vorbestimmten Frequenz oder mit Frequenzen aus einem vorbestimmten Frequenzbereich aus einem auf diesem Signalzweigabschnitt anliegenden Signal ausgekoppelt werden. Weiter umfasst die Antenneneinheit 4 einen Signalpegeldetektor 19 zur Bestimmung des Signalpegels des derart ausgekoppelten Signalanteils. Dieser Signalpegeldetektor 19 kann beispielsweise ein Spannungssignal erzeugen, welches den Signalpegel repräsentiert, insbesondere proportional dazu ist. Weiter umfasst die Antenneneinheit 4 einen Komparator 20, der den derart bestimmten Signalpegel mit einem vorbestimmten Schwellwert vergleicht. Ein Signalausgang des Komparators ist signaltechnisch mit der Steuereinrichtung 8 verbunden.

Das Signalauskopplungsmittel 18, der Signalpegeldetektor 19 sowie der Komparator 20 dienen zur Einstellung eines Sendemodus bzw. eines Empfangsmodus der Antenneneinheit 4. Insbesondere kann der Sendemodus aktiviert werden, wenn durch die Steuereinrichtung 8 detektiert wird, dass der Signalpegel des ausgekoppelten Signalanteils größer als der oder gleich dem vorbestimmten Schwellwert ist. In diesem Fall kann die Steuereinrichtung 8 die Schaltmittel 14 derart ansteuern, dass die Signalverbindung zwischen der geräteseitigen Signalschnittstelle 5 und der antennenseitigen Signalschnittstelle 6 über die Sendeverstärkereinrichtung 10 erfolgt. Detektiert die Steuereinrichtung 8, dass der Signalpegel des ausgekoppelten Signalanteils kleiner als der vorbestimmte Schwellwert ist, so kann der Empfangsmodus aktiviert werden und die Schaltmittel 14 derart angesteuert werden, dass die Signalverbindung zwischen antennenseitiger Signalschnittstelle und geräteseitiger Signalschnittstelle 5 über die Empfangsverstärkereinrichtung 13 erfolgt. Weiter ist es möglich, dass der Kalibriervorgang nur dann durchgeführt wird, wenn sich die Antenneneinheit 4 im Sendemodus befindet.

Fig. 4 zeigt ein schematisches Flussdiagramm eines erfindungsgemäßen Verfahrens. In einem ersten Schritt S1 wird ein Sendesystem 1 bzw. eine Signalbereitstellungseinheit 2 und eine Antenneneinheit 4 (siehe z.B. Fig. 1) eingeschaltet bzw. aktiviert. Dies kann beispielsweise erfolgen, indem das Sendesystem 1 bzw. die Signalbereitstellungseinheit 2 und die Antenneneinheit 4 von einem nicht vollständig betriebsfähigen Zustand in einen vollständig betriebsfähigen Zustand versetzt wird, beispielsweise durch Herstellen der Energieversorgung.

In einem zweiten Schritt S2 wird von der Signalbereitstellungseinheit 2 ein Kalibriersignal erzeugt, wobei das Kalibriersignal mit der maximal von der Signalbereitstellungseinheit 2 erzeugbaren Signalstärke erzeugt wird. Die maximal erzeugbare Signalstärke kann z.B. die maximale Signalleistung der Signalbereitstellungseinheit 2 sein. Dieses Kalibriersignal wird von der Signalbereitstellungseinheit 2 über das in Fig. 1 dargestellte Koaxialkabel 3 an die Antenneneinheit 4 übertragen und von der Antenneneinheit 4 empfangen. In einem dritten Schritt S3 wird die Signalstärke des Kalibriersignals bestimmt, insbesondere mittels des in Fig. 1 dargestellten Leistungsdetektors 11. Insbesondere kann die Signalstärke des über die Dämpfereinrichtung 9 sowie über die Sendeverstärkereinrichtung 10 übertragenen Kalibriersignals bestimmt werden. In einem vierten Schritt S4 wird die derart bestimmte Signalstärke des Kalibriersignals mit einer Referenz-Signalstärke verglichen. In einem fünften Schritt S5 wird ein Dämpfungsfaktor einer Dämpfereinrichtung 9 der Antenneneinheit 4 derart eingestellt, dass die Differenz zwischen der Referenz-Signalstärke und der bestimmten Signalstärke des Kalibriersignals minimiert wird. In einem sechsten Schritt S6 wird der Kalibriervorgang beendet, wobei dann die Antenneneinheit 4, insbesondere die Dämpfereinrichtung 9, in einem nachfolgenden Normalbetrieb mit dem vorhergehend bestimmten Dämpfungsfaktor betrieben wird.

Es ist möglich, dass während der Sequenz des ersten Schritts S1 bis zum sechsten Schritt S6 auch eine Temperatur der Antenneneinheit 4 und/oder eine Versorgungsspannungshöhe der Versorgungsspannung der Antenneneinheit 4 bestimmt wird. Diese kann/können abgespeichert werden.

In einem sich an den sechsten Schritt S6 anschließenden Normalbetrieb der Antenneneinheit 4 kann dann fortlaufend die Temperatur erfasst und mit der abgespeicherten Temperatur während des Kalibriervorgangs verglichen werden, wobei der während des Kalibriervorgangs bestimmte Dämpfungsfaktor wie vorhergehend in Abhängigkeit der Differenz verändert werden kann. Entsprechendes gilt für die Versorgungsspannungshöhe. Weiter kann auch die Sendesignalstärke mittels des Leistungsdetektors 11 im Normalbetrieb, also nach Beendigung des Kalibriervorgangs im sechsten Schritt S6, erfasst werden. Übersteigt die Sendesignalstärke eine maximal zulässige Sendesignalstärke, so kann der im Kalibriervorgang bestimmte Dämpfungsfaktor ebenfalls verändert, insbesondere erhöht, werden.

Fig. 5 zeigt eine weitere Ausführungsform eines erfindungsgemäßen Sendesystems 1. Dieses ist im Wesentlichen wie das in Fig. 1 dargestellte Sendesystem 1 ausgebildet. Daher kann auf die entsprechenden Erläuterungen zu Fig. 1 verwiesen werden. Im Unterschied zu der in Fig. 1 dargestellten Ausführungsform umfasst die Antenneneinheit 4 die Antenne 7. Die antennenseitige Signalschnittstelle 6 kann in diesem Fall einen Signalschnittstelle eines so genannten Front-End-Moduls 22 sein, welches die Sendeverstärkereinrichtung 10 als auch den Leistungsdetektor 11 und den Temperatursensor 12 umfasst.

Weiter umfasst die Antenneneinheit 4 nicht die zwischen geräteseitiger Schnittstelle 5 und Sendeverstärkereinrichtung 10 angeordnete Dämpfereinrichtung 9. Weiter dargestellt ist, dass die Sendeverstärkereinrichtung 10 über eine zusätzliche Steuerleitung 21 zur Einstellung der Verstärkung mit der Steuereinrichtung 8 signaltechnisch verbunden ist. Die Sendeverstärkereinrichtung 10 ist somit eine Verstärkereinrichtung mit einstellbarem Verstärkungsfaktor und bildet die in Fig. 1 von der Dämpfereinrichtung 9 gebildete Einrichtung zur Einstellung der Signalstärke.

Die Einstellung der Höhe der Verstärkung und somit des Verstärkungsfaktors der Sendeverstärkereinrichtung 10 kann z.B. durch eine Änderung des Arbeitspunkts des Verstärkers 10 erreicht werden. Dies kann durch die Höhe der Spannung eines über die Steuerleitung 21 übertragenen Spannungssignals erfolgen. Eine Dämpfeinrichtung 9 wie in der in Fig. 1 dargestellten Ausführungsform kann somit entfallen.
- 1: Sendesystem
- 2: Signalbereitstellungseinheit
- 3: Koaxialkabel
- 4: Antenneneinheit
- 5: geräteseitige Signalschnittstelle
- 6: antennenseitige Signalschnittstelle
- 7: Antenne
- 8: Steuereinrichtung
- 9: Dämpfereinrichtung
- 10: Verstärkereinrichtung
- 11: Leistungsdetektor
- 12: Temperatursensor
- 13: weitere Verstärkereinrichtung
- 14: Schaltmittel
- 15: widerstandsseitige Signalschnittstelle
- 16: Ersatzwiderstand
- 17: weiteres Schaltmittel
- 18: Signalauskopplungsmittel
- 19: Signalpegeldetektor
- 20: Komparator
- 21: Steuerleitung
- 22: Integrierter Schaltkreis / Front-End-Modul
- S1: erster Schritt
- S2: zweiter Schritt
- S3: dritter Schritt
- S4: vierter Schritt
- S5: fünfter Schritt
- S6: sechster Schritt

## Patentansprüche

1. Verfahren zum Betrieb einer Antenneneinheit (4), wobei die Antenneneinheit (4) eine antennenseitige Signalschnittstelle (6) und eine geräteseitige Signalschnittstelle (5), eine Steuereinrichtung (8), mindestens eine Einrichtung zur Einstellung einer Signalstärke eines Sendesignals und mindestens eine Einrichtung zur Erfassung einer Signalstärke des Sendesignals umfasst, wobei in einem Kalibriervorgang ein Kalibriersignal über die geräteseitige Signalschnittstelle (5) empfangen wird, wobei die Signalstärke des Kalibriersignals bestimmt wird, wobei die bestimmte Signalstärke mit einer Referenz-Signalstärke verglichen wird, wobei ein Verstärkungsfaktor der mindestens einen Einrichtung zur Einstellung der Signalstärke derart eingestellt wird, dass die Differenz zwischen der Referenz-Signalstärke und einer Signalstärke des verstärkten Kalibriersignals minimiert wird, wobei die Antenneneinheit (4) nach Beendigung des Kalibriervorgangs mit dem derart eingestellten Verstärkungsfaktor betrieben wird, wobei die Antenneneinheit (4) mindestens einen Sendesignalzweig umfasst, wobei während des Kalibriervorgangs das Kalibriersignal nicht an eine Antenne (7) übertragen wird,
**dadurch gekennzeichnet, dass**
die Einrichtung zur Erfassung einer Signalstärke in dem mindestens einen Sendesignalzweig angeordnet ist, wobei der Sendesignalzweig zur Übertragung eines Sendesignals von der geräteseitigen Signalschnittstelle an die antennenseitigen Signalschnittstelle dient.

2. Verfahren nach Anspruch 1, **dadurch gekennzeichnet, dass** das Kalibriersignal von einer Signalbereitstellungseinheit (2) erzeugt und über ein Signalverbindungsmittel (3) über die geräteseitige Signalschnittstelle (5) an die Antenneneinheit (4) übertragen wird.

3. Verfahren nach Anspruch 2, **dadurch gekennzeichnet, dass** die Signalbereitstellungseinheit (2) das Kalibriersignal mit der maximal erzeugbaren Signalstärke oder mit einer Signalstärke erzeugt, die einem vorbestimmten Anteil der maximalen Signalstärke entspricht.

4. Verfahren nach Anspruch 3, **dadurch gekennzeichnet, dass** die Referenz-Signalstärke derart bestimmt wird, dass das Verhältnis von Referenz-Signalstärke zu der vorbestimmten maximalen Sendesignalstärke gleich dem Verhältnis von Signalstärke des von der Signalbereitstellungseinheit (2) erzeugten Signals zur maximal erzeugbaren Signalstärke ist.

5. Verfahren nach einem der vorangegangenen Ansprüche, **dadurch gekennzeichnet, dass** ein Kalibriervorgang nach jedem Einschalten oder Aktivieren der Antenneneinheit (4) durchgeführt wird.

6. Verfahren nach einem der vorangegangenen Ansprüche, **dadurch gekennzeichnet, dass** die Einrichtung zur Einstellung der Signalstärke eine Dämpfereinrichtung (9) oder eine Verstärkereinrichtung (10) ist.

7. Verfahren nach einem der vorangegangenen Ansprüche, **dadurch gekennzeichnet, dass** durch die Einrichtung zur Einstellung der Signalstärke sowohl eine Signalstärke eines Sendesignals als auch eine Signalstärke eines Empfangssignals einstellbar ist.

8. Verfahren nach einem der vorangegangen Ansprüche, **dadurch gekennzeichnet, dass** eine Temperatur oder eine Temperaturänderung der Antenneneinheit (4) bestimmt wird, wobei der Verstärkungsfaktor der Einrichtung zur Einstellung der Signalstärke in Abhängigkeit der Temperatur oder der Temperaturänderung verändert wird.

9. Verfahren nach einem der vorangegangen Ansprüche, **dadurch gekennzeichnet, dass** eine Versorgungsspannung der Antenneneinheit (4) bestimmt wird, wobei der Verstärkungsfaktor der Einrichtung zur Einstellung der Signalstärke in Abhängigkeit der Versorgungsspannung verändert wird.

10. Verfahren nach einem der vorangegangenen Ansprüche, **dadurch gekennzeichnet, dass** ein Sendemodus von der Antenneneinheit (4) aktiviert wird, wobei der Kalibriervorgang im Sendemodus durchgeführt wird.

11. Verfahren nach einem der vorangegangen Ansprüche, **dadurch gekennzeichnet, dass** der Verstärkungsfaktor zu Beginn des Kalibriervorgangs in Abhängigkeit zumindest eines Verstärkungsfaktors bestimmt wird, der in einem vorhergehenden Kalibriervorgang bestimmt wurde.

12. Verfahren nach einem der vorangegangen Ansprüche, **dadurch gekennzeichnet, dass** die Steuereinrichtung (8) einen Fehlerzustand detektiert, wenn die minimierte Differenz größer als ein vorbestimmter Schwellwert ist.

13. Verfahren nach einem der vorangegangen Ansprüche, **dadurch gekennzeichnet, dass** eine Signalstärke eines Sendesignals bestimmt wird, wobei der im vorangegangenen Kalibriervorgang bestimmte Verstärkungsfaktor in Abhängigkeit der Signalstärke verändert wird.

14. Selbstkalibrierende Antenneneinheit, wobei die Antenneneinheit (4) eine antennenseitige Signalschnittstelle (6) und eine geräteseitige Signalschnittstelle (5), eine Steuereinrichtung (8), mindestens eine Einrichtung zur Einstellung einer Signalstärke eines Sendesignals und mindestens eine Einrichtung zur Erfassung einer Signalstärke des Sendesignals umfasst, wobei in einem Kalibriervorgang ein Kalibriersignal über die geräteseitige Signalschnittstelle (5) empfangbar ist, wobei die Signalstärke des Kalibriersignals bestimmbar ist, wobei die bestimmte Signalstärke mit einer Referenz-Signalstärke vergleichbar ist, wobei ein Verstärkungsfaktor der mindestens einen Einrichtung zur Einstellung der Signalstärke derart einstellbar ist, dass die Differenz zwischen der Referenz-Signalstärke und einer Signalstärke des verstärkten Kalibriersignals minimiert wird, wobei die Antenneneinheit (4) nach Beendigung des Kalibriervorgangs mit dem derart eingestellten Verstärkungsfaktor betreibbar ist, wobei die Antenneneinheit (4) mindestens einen Sendesignalzweig umfasst, wobei während des Kalibriervorgangs das Kalibriersignal nicht an eine Antenne (7) übertragen wird
**dadurch gekennzeichnet, dass**
die Einrichtung zur Erfassung einer Signalstärke in dem mindestens einen Sendesignalzweig angeordnet ist, wobei der Sendesignalzweig zur Übertragung eines Sendesignals von der geräteseitigen Signalschnittstelle an die antennenseitigen Signalschnittstelle dient.

15. Sendesystem, umfassend eine selbstkalibrierende Antenneneinheit (4) nach Anspruch 14 sowie eine Signalbereitstellungseinheit (2), wobei die Antenneneinheit (4) und die Signalbereitstellungseinheit (2) über ein Signalverbindungsmittel verbunden sind.

## Claims

1. Method for operating an antenna unit (4), wherein the antenna unit (4) comprises an on-antenna signal interface (6) and an on-device signal interface (5), a control device (8), at least one device for adjusting a signal strength of a transmission signal and at least one device for detecting a signal strength of the transmission signal, wherein a calibration process involves a calibration signal being received via the on-device signal interface (5), wherein the signal strength of the calibration signal is determined, wherein the determined signal strength is compared with a reference signal strength, wherein a gain factor of the at least one device for adjusting the signal strength is set such that the difference between the reference signal strength and a signal strength of the amplified calibration signal is minimized, wherein the antenna unit (4) is operated with the gain factor set in this manner following completion of the calibration process, wherein the antenna unit (4) comprises at least one transmission signal branch, wherein during the calibration process the calibration signal is not transmitted to an antenna (7), **characterized in that**
the device for detecting a signal strength is arranged in the at least one transmission signal branch, wherein the transmission signal branch serves to transmit a transmission signal from the on-device signal interface to the on-antenna signal interface.

2. Method according to claim 1, **characterized in that** the calibration signal is generated by a signal providing unit (2) and transmitted via a signal connection means (3) through the on-device signal interface (5) to the antenna unit (4).

3. Method according to claim 2, **characterized in that** the signal providing unit (2) generates the calibration signal at the maximum signal strength that can be generated or at a signal strength which corresponds to a predetermined proportion of the maximum signal strength.

4. Method according to claim 3, **characterized in that** the reference signal strength is determined such that the ratio of reference signal strength to the predetermined maximum transmission signal strength is equal to the ratio of the signal strength of the signal generated by the signal providing unit (2) to the maximum signal strength that can be generated.

5. Method according to any one of the preceding claims, **characterized in that** a calibration process is performed after each time the antenna unit (4) is switched on or activated.

6. Method according to any one of the preceding claims, **characterized in that** the device for adjusting the signal strength is a damper device (9) or an amplifier device (10).

7. Method according to any one of the preceding claims, **characterized in that** the device for adjusting the signal strength is capable of adjusting both a signal strength of a transmission signal and a signal strength of a reception signal.

8. Method according to any one of the preceding claims, **characterized in that** a temperature or a temperature variation in the antenna unit (4) is determined, wherein the gain factor of the device for adjusting the signal strength is varied depending on the temperature or the temperature variation.

9. Method according to any one of the preceding claims, **characterized in that** a supply voltage of the antenna unit (4) is determined, wherein the gain factor of the device for adjusting the signal strength is changed depending on the supply voltage.

10. Method according to any one of the preceding claims, **characterized in that** a transmission mode is activated by the antenna unit (4), wherein the calibration process is carried out in the transmission mode.

11. Method according to any one of the preceding claims, **characterized in that** the gain factor at the beginning of the calibration process is determined depending on at least one gain factor that was determined in a previous calibration process.

12. Method according to any one of the preceding claims, **characterized in that** the control device (8) detects an error state when the minimized difference is greater than a predetermined threshold value.

13. Method according to any one of the preceding claims, **characterized in that** a signal strength of a transmission signal is determined, wherein the gain factor determined in the previous calibration process is changed depending on the signal strength.

14. Self-calibrating antenna unit, wherein the antenna unit (4) comprises an on-antenna signal interface (6) and an on-device signal interface (5), a control device (8), at least one device for adjusting a signal strength of a transmission signal and at least one device for detecting a signal strength of the transmission signal, wherein a calibration process involves a calibration signal being receivable via the on-device signal interface (5), wherein the signal strength of the calibration signal is determinable, wherein the determined signal strength is comparable with a reference signal strength, wherein a gain factor of the at least one device for adjusting the signal strength is adjustable such that the difference between the reference signal strength and a signal strength of the amplified calibration signal is minimized, wherein the antenna unit (4) is operable with the gain factor set in this manner following completion of the calibration process, wherein the antenna unit (4) comprises at least one transmission signal branch, wherein during the calibration process the calibration signal is not transmitted to an antenna (7), **characterized in that**
the device for detecting a signal strength is arranged in the at least one transmission signal branch, wherein the transmission signal branch serves to transmit a transmission signal from the on-device signal interface to the on-antenna signal interface.

15. Transmission system, comprising a self-calibrating antenna unit (4) according to claim 14 and a signal providing unit (2), wherein the antenna unit (4) and the signal providing unit (2) are connected via a signal connection means.

## Revendications

1. Procédé pour faire fonctionner une unité d'antenne (4), dans lequel l'unité d'antenne (4) comprend une interface de signal (6) côté antenne et une interface de signal (5) côté appareil, un appareil de commande (8), au moins un appareil pour régler une intensité de signal d'un signal d'émission et au moins un appareil pour détecter une intensité de signal du signal d'émission, dans lequel, lors d'un processus d'étalonnage, un signal d'étalonnage est reçu par l'intermédiaire de l'interface de signal (5) côté appareil, dans lequel l'intensité de signal du signal d'étalonnage est déterminée, dans lequel l'intensité de signal déterminée est comparée à une intensité de signal de référence, dans lequel un facteur d'amplification de l'au moins un appareil de réglage de l'intensité de signal est réglé de sorte que la différence entre l'intensité de signal de référence et une intensité de signal du signal d'étalonnage amplifié est minimisée, dans lequel l'unité d'antenne (4) est exploitée avec le facteur d'amplification ainsi réglé à la fin du processus d'étalonnage, dans lequel l'unité d'antenne (4) comprend au moins une branche de signal d'émission, dans lequel le signal d'étalonnage n'est pas transmis à une antenne (7) pendant le processus d'étalonnage, **caractérisé en ce que**
l'appareil de détection d'une intensité de signal est disposé dans la au moins une branche de signal d'émission, dans lequel la branche de signal d'émission sert à transmettre un signal d'émission de l'interface de signal côté appareil à l'interface de signal côté antenne.

2. Procédé selon la revendication 1, **caractérisé en ce que** le signal d'étalonnage est généré par une unité de fourniture de signal (2) et est transmis à l'unité d'antenne (4) par l'intermédiaire d'un moyen de connexion de signal (3) par l'intermédiaire de l'interface de signal côté appareil (5).

3. Procédé selon la revendication 2, **caractérisé en ce que** l'unité de fourniture de signal (2) génère le signal d'étalonnage avec l'intensité de signal maximale pouvant être générée ou avec une intensité de signal qui correspond à une part prédéterminée de l'intensité de signal maximale.

4. Procédé selon la revendication 3, **caractérisé en ce que** l'intensité de signal de référence est déterminée de sorte que le rapport entre l'intensité de signal de référence et l'intensité de signal d'émission maximale prédéterminée est égal au rapport entre l'intensité de signal généré par l'unité de fourniture de signal (2) et l'intensité de signal maximale pouvant être générée.

5. Procédé selon l'une quelconque des revendications précédentes, **caractérisé en ce qu'**un processus d'étalonnage est effectué après chaque mise sous tension ou activation de l'unité d'antenne (4).

6. Procédé selon l'une quelconque des revendications précédentes, **caractérisé en ce que** l'appareil de réglage de l'intensité de signal est un appareil d'atténuation (9) ou un appareil d'amplification (10).

7. Procédé selon l'une quelconque des revendications précédentes, **caractérisé en ce que** l'appareil de réglage de l'intensité de signal permet de régler aussi bien une intensité de signal d'un signal d'émission qu'une intensité de signal d'un signal de réception.

8. Procédé selon l'une quelconque des revendications précédentes, **caractérisé en ce qu'**une température ou une variation de température de l'unité d'antenne (4) est déterminée, dans lequel le facteur d'amplification de l'appareil de réglage de l'intensité de signal est varié en fonction de la température ou de la variation de température.

9. Procédé selon l'une quelconque des revendications précédentes, **caractérisé en ce qu'**une tension d'alimentation de l'unité d'antenne (4) est déterminée, dans lequel le facteur d'amplification de l'appareil de réglage de l'intensité de signal est varié en fonction de la tension d'alimentation.

10. Procédé selon l'une quelconque des revendications précédentes, **caractérisé en ce qu'**un mode d'émission est activé par l'unité d'antenne (4), dans lequel le processus d'étalonnage est effectué dans le mode d'émission.

11. Procédé selon l'une quelconque des revendications précédentes, **caractérisé en ce que** le facteur d'amplification est déterminé au début du processus d'étalonnage en fonction d'au moins un facteur d'amplification qui a été déterminé lors d'un processus d'étalonnage précédent.

12. Procédé selon l'une quelconque des revendications précédentes, **caractérisé en ce que** l'appareil de commande (8) détecte un état d'erreur lorsque la différence minimisée est supérieure à une valeur seuil prédéterminée.

13. Procédé selon l'une quelconque des revendications précédentes, **caractérisé en ce qu'**une intensité de signal d'un signal d'émission est déterminée, dans lequel le facteur d'amplification déterminé lors du processus d'étalonnage précédent est varié en fonction de l'intensité de signal.

14. Unité d'antenne à auto-étalonnage, dans laquelle l'unité d'antenne (4) comprend une interface de signal (6) côté antenne et une interface de signal (5) côté appareil, un appareil de commande (8), au moins un appareil pour régler une intensité de signal d'un signal d'émission et au moins un appareil pour détecter une intensité de signal du signal d'émission, dans lequel, lors d'un processus d'étalonnage, un signal d'étalonnage peut être reçu par l'intermédiaire de l'interface de signal (5) côté appareil, dans lequel l'intensité de signal du signal d'étalonnage peut être déterminée, dans lequel l'intensité de signal déterminée peut être comparée à une intensité de signal de référence, dans lequel un facteur d'amplification de l'au moins un appareil de réglage de l'intensité de signal peut être réglé de sorte que la différence entre l'intensité de signal de référence et une intensité de signal du signal d'étalonnage amplifié est minimisée, dans lequel l'unité d'antenne (4) peut être exploitée avec le facteur d'amplification ainsi réglé à la fin du processus d'étalonnage, dans lequel l'unité d'antenne (4) comprend au moins une branche de signal d'émission, dans lequel le signal d'étalonnage n'est pas transmis à une antenne (7) pendant le processus d'étalonnage, **caractérisé en ce que**
l'appareil de détection d'une intensité de signal est disposé dans la au moins une branche de signal d'émission, dans lequel la branche de signal d'émission sert à transmettre un signal d'émission de l'interface de signal côté appareil à l'interface de signal côté antenne.

15. Système d'émission, comprenant une unité d'antenne à auto-étalonnage (4) selon la revendication 14 ainsi qu'une unité de fourniture de signal (2), dans lequel l'unité d'antenne (4) et l'unité de fourniture de signal (2) sont connectées par un moyen de connexion de signal.
